# EUROPÄISCHE PATENTSCHRIFT

(11) **EP 2 513 987 B1**
(45) Veröffentlichungstag und Bekanntmachung des Hinweises auf die Patenterteilung: **10.06.2015**
(21) Anmeldenummer: 10796367.0
(22) Anmeldetag: 15.12.2010
(51) Int. Cl.: H01L 35/30, H01L 35/10

(54) **THERMOELEKTRISCHE EINHEIT**
THERMOELECTRIC UNIT
UNITE THERMOELECTRIQUE

(30) Priorität: 16.12.2009 DE 102009058674
(43) Veröffentlichungstag der Anmeldung: 24.10.2012
(73) Patentinhaber: MAHLE Behr GmbH & Co. KG, 70469 Stuttgart (DE)
(72) Erfinder: BREHM, Holger, 71729 Erdmannhausen (DE); HIMMER, Thomas, 73326 Reichenbach (Deggingen) (DE); HECKENBERGER, Thomas, 70771 Leinfelden-Echterdingen (DE); RIEDEL, Rudolf, 75173 Pforzheim (DE)
(74) Vertreter: Grauel, Andreas
(86) Internationale Anmeldenummer: PCT/EP2010/069784
(87) Internationale Veröffentlichungsnummer: WO 2011/083006

(56) Entgegenhaltungen:
- WO-A1-2007/026432
- WO-A1-2009/093653
- AT-A2- 506 262
- DE-A1- 2 430 221
- DE-A1- 10 151 072
- GB-A- 2 110 873
- JP-A- 2005 235 958
- JP-A- 2006 125 341
- US-A- 3 269 873
- US-A- 3 607 444
- US-A1- 2006 157 102

## Beschreibung

Die vorliegende Erfindung bezieht sich auf eine thermoelektrische Einheit gemäß dem Anspruch 1.

Die im Abgas in Form von Wärme gespeicherte Energie wird bisher ungenutzt an die Umgebung abgeführt. Um den Wirkungsgrad einer Anlage, z.B. eines Fahrzeugs, zu erhöhen und folglich den CO₂-Ausstoß im Betrieb zu senken, kann ein thermoelektrischer Generator (TEG) implementiert werden, dessen thermoelektrisches Modul (TEM) einen Teil der Wärme in elektrische Energie umwandelt und diese an die Anlage zurückführt. Der TEG kann mit unterschiedlichem Nutzen an beliebiger Stelle im Abgasstrang oder in der Abgasrückführung untergebracht sein. Strombetrieben kann der TEG auch als thermoelektrischer Heizer oder Kühler (TE-HK) genutzt werden.

Die EP 1 475 532 A2 offenbart einen thermoelektrischen Generator mit einem thermoelektrischen Element, das Abgas von einem Motor als eine Hochtemperatur-Wärmequelle und ein Motorkühlmittel als eine Niedertemperatur-Wärmequelle zur Erzeugung von Elektrizität nutzt. Ein Ventil regelt die Zuführung des Abgases zu dem thermoelektrischen Element entsprechend der Motorlast.

Die US 2006/157102 A1 offenbart eine thermoelektrische Einheit mit Flachrohre, die benachbart zueinander angeordnet sind, wobei die thermoelektrischen Module zwischen benachbarten Flachrohren angeordnet sind. Die WO 2007/026432 A1 offenbart eine thermoelektrische Einheit, wobei die thermoelektrischen Elemente zwischen den Außenflächen eines Innenflachrohres und zumindest einer Außenfläche eines weiteren Flachrohres, welches durch das Aufeinanderstapeln von Scheibenelementen gebildet ist, angeordnet sind. Die Innenflachrohre werden dabei über Diffusoren, welche über Böden an die Innenflachrohre angebunden sind, durchströmt. Die weiteren Flachrohre, welche durch die Scheibenelemente gebildet sind, werden nicht an ihren Außenflächen umströmt, sondern nach dem Prinzip eines Wärmeübertragers in Stapelscheibenbauweise im Inneren durchströmt. Die übereinandergestapelten weiteren Flachrohre bilden dabei Zwischenräume zueinander aus, in welchen die Innenflachrohre und die thermoelektrischen Elemente angeordnet sind.

Herkömmliche TEM gemäß dem Stand der Technik sind auf Grund ihrer Gestaltung und Verbindungstechnik nicht optimal für den Einsatz in einem TEG geeignet und auch weniger effektiv. Desweiteren müssen die TEM in optimaler Weise elektrisch ein- und angebunden sein.

Herkömmliche TEG sind auf Grund des erhöhten Wärmedurchgangswiderstandes zwischen thermoelektrisch aktiven Materialien und einer Wärmequelle / Wärmesenke wenig effizient. Auch hat sich eine Einbindung des TEM in einen Wärmetauscher als wenig praktikabel erwiesen. Bislang verfügbare Verbindungstechniken sind teilweise nicht hochtemperaturstabil, Zudem besteht häufig auf der gasseitigen Kontaktierung des TEM im Wärmetauscher lediglich ein geringer Wärmeübergang. Gemäß dem Stand der Technik sind demnach herkömmliche TEM auf Grund ihrer Gestaltung und Verbindungstechnik nicht optimal für den Einsatz in einem TEG geeignet und auch weniger effektiv. Die elektrische Anbindung ist häufig aufwändig und instabil.

Es ist die Aufgabe der vorliegenden Erfindung eine verbesserte thermoelektrische Einheit zu schaffen.

Diese Aufgabe wird durch eine thermoelektrische Einheit gemäß Anspruch 1 gelöst.

Der vorliegenden Erfindung liegt die Erkenntnis zugrunde, dass durch eine günstige Ausgestaltung der elektrischen Verbindungskontakte sehr einfach eine größere Menge von thermoelektrischen Modulen miteinander verschaltet werden kann. Auf diese Weise können auch bei kompakt gebauten Wärmetauschern die Vorteile der thermoelektrischen Elemente effizient ausgenutzt werden.

Die vorliegende Erfindung schafft eine thermoelektrische Einheit zum elektrischen Verbinden einer Mehrzahl von thermoelektrischen Modulen, wobei die thermoelektrische Einheit folgende Merkmale aufweist: Ein erstes thermoelektrisches Modul, das eine Mehrzahl von miteinander verschalteten thermoelektrischen Elementen aufweist, wobei das erste thermoelektrische Modul zwischen einer Hauptfläche eines Innenflachrohres und einer Hauptfläche eines Außenflachrohres eines doppelwandigen Kühlungsrohres angeordnet ist; ein zweites thermoelektrisches Modul, das eine Mehrzahl von miteinander verschalteten thermoelektrischen Elementen aufweist, wobei das zweite thermoelektrische Modul zwischen einer weiteren Hauptfläche des Innenflachrohres und einer weiteren Hauptfläche des Außenflachrohres des doppelwandigen Kühlungsrohres und/oder zwischen einer Hauptfläche eines Innenflachrohres und einer Hauptfläche eines Außenflachrohres eines weiteren doppelwandigen Kühlungsrohres angeordnet ist; und einen elektrischen Verbinder, der ausgebildet ist, um das erste thermoelektrische Modul mit dem zweiten thermoelektrischen Modul elektrisch leitfähig zu verbinden.

Die thermoelektrischen Module (oder kurz TEM) können z.B. in einem Wärmetauscher eingesetzt werden. Der Wärmetauscher kann in einem Fahrzeug entweder als thermoelektrischer Generator oder als thermoelektrischer Heizer und Kühler zum Einsatz kommen. Zum Beispiel werden bei einem Einsatz des Wärmetauschers als thermoelektrischer Generator oder TEG zwei unterschiedlich temperierte und räumlich getrennte Medien oder Fluide so aneinander vorbei geführt, dass in den thermoelektrischen Modulen ein elektrischer Strom erzeugt wird. Bei den thermoelektrischen Elementen kann es sich beispielsweise um unterschiedlich dotierte Halbleitermaterialien handeln. Die thermoelektrischen Elemente können als eine Mehrzahl von Blöcken zwischen den Hauptflächen des Innen- und Außenflachrohres angeordnet sein und elektrische Leiter aufweisen, über die die einzelnen Blöcke elektrisch leitfähig miteinander verbunden sind. So weist ein doppelwandiges Kühlungsrohr im Allgemeinen zwei im Querschnitt betrachtet übereinander angeordnete thermoelektrische Module oder TEM auf. Das doppelwandige Kühlungsrohr kann somit auch als TEM-Rohr bezeichnet werden. Das doppelwandige Kühlungsrohr kann z.B. einen rechteckigen Querschnitt aufweisen, sich also aus einem Innenrechteckrohr und einem dieses umgebenen Außenrechteckrohr zusammensetzen. Bei den Hauptflächen des Innenflachrohres und des Außenflachrohres handelt es sich somit um die einander gegenüber liegenden größeren Flächen des inneren und äußeren Rechteckrohres. Beispielsweise wird innerhalb des Innenrohres des TEM-Rohres eines der zwei unterschiedlich temperierten Fluide des Wärmetauschers geführt. Es kann sich dabei z.B. um ein Kühlmittel aus dem Motorkühlkreislauf des Fahrzeugs handeln. Das andere der zwei unterschiedlich temperierten Fluide kann z.B. Abgas aus einem Verbrennungsmotor des Fahrzeugs sein und an eine Außenseite des Außenrohres des doppelwandigen Kühlungsrohres geführt werden. So kann infolge des Temperaturunterschieds der zwei Medien Strom in den zwischen Innenrohr und Außenrohr angeordneten thermoelektrischen Modulen erzeugt werden. Ein Wärmetauscher weist im Allgemeinen eine Mehrzahl von z.B. schichtartig angeordneten doppelwandigen Kühlungsrohren mit jeweils einem thermoelektrischen Modul in jedem Zwischenraum zwischen den Hauptflächen der Innen- und Außenflachrohre auf. Bei den elektrischen Verbindern kann es sich um unterschiedlich ausgeformte und elektrisch leitfähige Metallelemente handeln. Diese können ausgebildet sein, um die zwei thermoelektrischen Module innerhalb eines doppelwandigen Kühlungsrohres zu verbinden und gleichzeitig oder alternativ diese mit den thermoelektrischen Modulen eines weiteren doppelwandigen Kühlungsrohres elektrisch leitfähig zu verbinden.

Gemäß einer Ausführungsform kann das Innenflachrohr des doppelwandigen Kühlungsrohres eine größere Länge als das Außenflachrohr des doppelwandigen Kühlungsrohres und das Innenflachrohr des weiteren doppelwandigen Kühlungsrohres eine größere Länge als das Außenflachrohr des weiteren doppelwandigen Kühlungsrohres aufweisen, derart, dass zumindest an einer Seite die Enden der Innenflachrohre über die entsprechenden Enden der Außenflachrohre vorstehen, wobei sich der elektrische Verbinder vom hervorstehenden Ende des Innenrohres des doppelwandigen Kühlungsrohres zu dem hervorstehenden Ende des Innenrohres des weiteren doppelwandigen Kühlungsrohres erstreckt. Vorteilhafterweise können so Leiterverbindungen zum elektrisch leitfähigen Verbinden von thermoelektrischen Modulen einer Mehrzahl von Kühlungsrohren auf einfache Weise positioniert und fixiert werden.

Beispielsweise kann der elektrische Verbinder als eine einteilige Klammer ausgebildet sein, die das Innenflachrohr an einer Seitenfläche des doppelwandigen Kühlungsrohres seitlich umspannt, wobei ein erstes Ende des Verbinders das erste thermoelektrische Modul des doppelwandigen Kühlungsrohres kontaktiert und ein zweites Ende oder ein Zwischenkontakt des Verbinders das weitere thermoelektrische Modul des doppelwandigen Kühlungsrohres kontaktiert. Ein derartiger elektrischer Verbinder ist einfach und kostengünstig herzustellen und unkompliziert in der Anwendung. Das Kontaktieren kann z.B. über ein Einschieben des Endes und des zweiten Endes oder des Zwischenkontaktes zwischen eines der Elemente des thermoelektrischen Moduls und das Innenflachrohr erfolgen. Die einteilige Klammer kann ganz an dem Innenflachrohr anliegen oder von einer Seitenfläche des Innenflachrohres beabstandet sein.

Gemäß einer weiteren Ausführungsform kann der elektrische Verbinder als eine einteilige Mehrfachklammer ausgebildet sein, die das Innenflachrohr des doppelwandigen Kühlungsrohres und das Innenflachrohr des mindestens einen weiteren doppelwandigen Kühlungsrohres an einer Seitenfläche seitlich umspannt, wobei die Mehrfachklammer ausgebildet ist, um zwei dem doppelwandigen Kühlungsrohr zugeordnete thermoelektrische Module mit mindestens einem thermoelektrischen Modul eines weiteren doppelwandigen Kühlungsrohres zu verbinden. Auch in dieser Ausführung ist der elektrische Verbinder einfach und kostengünstig in der Herstellung und ohne weiteres zu platzieren und zu befestigen, insbesondere, wenn es erforderlich ist, die thermoelektrischen Module von mehreren Kühlungsrohren zu verbinden.

Auch kann der elektrische Verbinder als eine mehrteilige Klammer ausgebildet sein, von der ein erster Teil eine Seitenfläche des Innenflachrohrs des doppelwandigen Kühlungsrohres umspannt und mindestens ein zweiter Teil das Innenflachrohr eines weiteren doppelwandigen Kühlungsrohres an einer Seitenfläche umspannt, wobei der erste Teil und der zweite Teil formschlüssig verbunden werden können, um zumindest ein dem doppelwandigen Kühlungsrohr zugeordnetes thermoelektrisches Modul mit mindestens einem dem weiteren doppelwandigen Kühlungsrohr zugeordneten thermoelektrischen Element elektrisch leitfähig zu verbinden. Beispielsweise können der eine Teil und der mindestens eine weitere Teil als gegeneinander eingreifbare Haken ausgebildet sein. Diese Ausführungsform bietet den Vorteil, dass durch die getrennten Arbeitsschritte des Positionierens und des Verbindens der zumindest zwei Teile der Klammer ein Anbringen und Entfernen des elektrischen Verbinders erleichtert werden kann.

Gemäß einer weiteren Ausführungsform kann der elektrische Verbinder um eine schmale Seite des Innenrohres gespannt sein und im Bereich einer die Hauptflächen des Innenrohres verbindenden Nebenfläche des Innenrohres eine Buchse aufweisen, die ausgebildet sein kann, um mit einem Einsteckleiter elektrisch leitfähig verbunden zu werden. Bei dem Einsteckleiter kann es sich z.B. um ein elektrisch isoliertes Kupferkabel oder um eine Leiterspange handeln, mit dem einzelne TEM-Rohre verbunden werden können oder eine Verbindung mit einer externen Stromversorgung hergestellt werden kann. Dies ermöglicht eine schnelle Kontaktierung der einzelnen thermoelektrischen Module auch über mehrere Kühlungsrohre hinweg.

Auch kann das Außenflachrohr des doppelwandigen Kühlungsrohres eine erste Öffnung aufweisen und an einer Hauptoberfläche des Außenflachrohres des weiteren doppelwandigen Kühlungsrohres eine zweite Öffnung aufweisen, die an einer der ersten Öffnung gegenüberliegenden Position angeordnet ist und wobei der elektrische Verbinder als Steckstift ausgebildet ist, der durch die erste Öffnung und die zweite Öffnung hindurch geführt ist. Über derartige Öffnungen in Verbindung mit Steckstiften besteht eine besonders platzsparende Möglichkeit zum elektrisch leitfähigen Verbinden von thermoelektrischen Modulen.

Gemäß einer Ausführungsform kann der Steckstift eine nicht-leitende Ummantelung aufweisen. Der Steckverbinder kann als ein Doppelstecker oder ein Leiterstift mit einem elektrisch leitfähigen Kern und einer elektrisch isolierten Ummantelung ausgeführt sein, so dass eine verbesserte elektrische Isolation des Kontakts zwischen den thermoelektrischen Modulen und einer Umgebung sichergestellt ist. Dies wird insbesondere bei widrigen Umgebungsbedingungen der thermoelektrischen Einheit wie im Fahrzeugeinsatz zu einer erhöhten Lebensdauer derselben führen.

Gemäß einer weiteren Ausführungsform kann der elektrische Verbinder einen ersten Teil aufweisen, der als ein mit dem thermoelektrischen Modul elektrisch leitfähig verbundener Dorn ausgebildet sein kann, der aus einer Öffnung einer Hauptfläche des Außenflachrohres des doppelwandigen Kühlungsrohres herausragt und wobei der elektrische Verbinder ferner einen zweiten Teil aufweisen kann, der ebenfalls als elektrisch leitfähiger Dorn ausgebildet sein kann, wobei der zweite Teil mit einem zweiten thermoelektrischen Modul leitfähig verbunden ist, das einem weiteren doppelwandigen Kühlungsrohr zugeordnet ist und wobei der zweite Teil aus einer Öffnung einer Hauptfläche des Außenflachrohres des zweiten doppelwandigen Kühlungsrohres herausragt. Dabei kann der erste und zweite Teil des elektrischen Verbinders in elektrisch leitfähigem Kontakt miteinander stehen. Zur elektrischen Verbindung des thermoelektrischen Moduls mit einem weiteren thermoelektrischen Modul kann dabei das doppelwandige Kühlungsrohr eng benachbart zu einem weiteren doppelwandigen Kühlungsrohr so angeordnet sein, so dass die mit dem jeweiligen thermoelektrischen Modul verbundenen Dorne einander kontaktieren können. Auch hier kann eine elektrische Isolierung des Dornes gegenüber dem umgebenden Medium vorgesehen sein, wodurch sich die vorstehend genannten Vorteile wiederum erreichen lassen.

Auch kann der elektrische Verbinder als ein Kabel ausgebildet sein, dessen Ende durch eine Öffnung einer Hauptfläche des Außenflachrohres des doppelwandigen Kühlungsrohres mit dem thermoelektrischen Modul stoffschlüssig und elektrisch leitend verbunden sein kann Bei dieser Ausführungsform kann der benötigte Materialaufwand besonders gering gehalten werden, wobei auch eine sichere elektrische Kontaktierung der einzelnen thermoelektrischen Module durch die stoffschlüssige Verbindung gewährleistet ist. Dagegen wird ein Herstellungsaufwand für eine derartige Verbindung höher sein, als ein Herstellungsund Befestigungsaufwand für das Verbinden mit einer entsprechend geformten Klammer.

Vorteilhafte Ausführungsbeispiele der vorliegenden Erfindung werden nachfolgend Bezug nehmend auf die beiliegenden Zeichnungen näher erläutert. Es zeigen:
- Fig. 1 bis 7: isometrische Darstellungen von ein- bzw. zweiteiligen Außen- bzw. Innenflachrohren eines TEM-Rohres, gemäß Ausführungsbeispielen der vorliegenden Erfindung;
- Fig. 8 und 9: isometrische Darstellungen von Außenflachrohren mit Öffnungen gemäß Ausführungsbeispielen der vorliegenden Erfindung;
- Fig. 10: eine isometrische Darstellung eines thermoelektrischen Moduls gemäß einem Ausführungsbeispiel der vorliegenden Erfindung;
- Fig. 11: eine isometrische Darstellung eines mit TE-Materialien bestückten Innenflachrohres gemäß einem Ausführungsbeispiel der vorliegenden Erfindung;
- Fig. 12: eine isometrische Darstellung eines mit TE-Materialien bestückten TEM-Rohres gemäß einem Ausführungsbeispiel der vorliegenden Erfindung;
- Fig. 13: einen Ausschnitt eines mit TE-Materialien bestückten TEM-Rohres in einer Schnittdarstellung gemäß einem Ausführungsbeispiel der vorliegenden Erfindung;
- Fig. 14: einen Detailausschnitt eines mit TE-Materialien bestückten TEM-Rohres in einer Schnittdarstellung gemäß einem Ausführungsbeispiel der vorliegenden Erfindung;
- Fig. 15 bis 17: isometrische Darstellungen von TEM-Rohr-Deckeln gemäß Ausführungsbeispielen der vorliegenden Erfindung;
- Fig. 18 und 19: isometrische Darstellungen zum Verbinden eines TEM-RohrDeckels mit einem TEM-Rohr gemäß Ausführungsbeispielen der vorliegenden Erfindung;
- Fig 20: eine Explosionsdarstellung zur Montage eines TEG gemäß einem Ausführungsbeispiel der vorliegenden Erfindung;
- Fig. 21 und 22: Schnittdarstellungen einer Anordnung eines Innenflachrohres gegenüber einem Außenflachrohr gemäß Ausführungsbeispielen der vorliegenden Erfindung;
- Fig. 23 bis 26: Darstellungen TEM-Rohren von mit Böden im Schnitt gemäß Ausführungsbeispielen der vorliegenden Erfindung;
- Fig. 27: eine isometrische Teildarstellung von mit Böden verbundenen TEM-Rohren gemäß einem Ausführungsbeispiel der vorliegenden Erfindung;
- Fig. 28: eine isometrische Teildarstellung eines Innenflachrohres mit TE-Modulen und Leiterverbinder gemäß einem Ausführungsbeispiel der vorliegenden Erfindung;
- Fig. 29: eine Teildarstellung im Schnitt des Innenflachrohres mit TE-Modulen und Leiterverbinder aus Fig. 28;
- Fig. 30: eine Teildarstellung im Schnitt des Innenflachrohres mit TE-Modulen und Leiterverbinder gemäß einem weiteren Ausführungsbeispiel der vorliegenden Erfindung;
- Fig. 31: eine isometrische Darstellung eines Leiterverbinders mit Buchse gemäß einem Ausführungsbeispiel der vorliegenden Erfindung;
- Fig. 32: eine isometrische Darstellung für eine Verschaltung von TEM-Innenflachrohren via Leiterverbindung gemäß einem Ausführungsbeispiel der vorliegenden Erfindung;
- Fig. 33: eine isometrische Darstellung eines zweiteiligen Leiterverbinders gemäß einem Ausführungsbeispiel der vorliegenden Erfindung;
- Fig. 34 bis 36: isometrische Darstellungen und eine Schnittteildarstellung für eine Verschaltung von TEM-Rohren mit zweiteiligem Leiterverbinder gemäß einem Ausführungsbeispiel der vorliegenden Erfindung;
- Fig. 37: eine isometrische Darstellung eines Leiterverbinders gemäß einem weiteren Ausführungsbeispiel der vorliegenden Erfindung;
- Fig. 38 und 39: isometrische Teildarstellungen für eine Verbindung von TEM-Rohren mit dem Leiterverbinder aus Fig. 37 gemäß einem Ausführungsbeispiel der vorliegenden Erfindung;
- Fig. 40: eine isometrische Darstellung eines Einsteckleiters gemäß einem Ausführungsbeispiel der vorliegenden Erfindung;
- Fig. 41: eine isometrische Teildarstellung eines Innenflachrohres mit dem Einsteckleiter aus Fig. 40;
- Fig. 42: eine isometrische Darstellung einer Einsteckbuchse gemäß einem weiteren Ausführungsbeispiel der vorliegenden Erfindung;
- Fig. 43: eine isometrische Teildarstellung eines TEM-Innenflachrohres mit der Einsteckbuchse aus Fig. 42;
- Fig. 44: eine isometrische Darstellung einer zweiteiligen Einsteckbuchse gemäß einem weiteren Ausführungsbeispiel der vorliegenden Erfindung;
- Fig. 45: eine isometrische Teildarstellung eines TEM-Innenflachrohres mit der zweiteiligen Einsteckbuchse aus Fig. 44;
- Fig. 46: eine isometrische Darstellung eines TEM-Rohr-Steckers gemäß einem Ausführungsbeispiel der vorliegenden Erfindung;
- Fig. 47: eine isometrische Darstellung für eine Verbindung eines TEM-Rohres mit dem TEM-Rohr-Stecker aus Fig. 46 gemäß einem Ausführungsbeispiel der vorliegenden Erfindung;
- Fig. 48 und 49: eine isometrische Darstellung und eine Schnittteildarstellung für eine Verschaltung von TEM-Rohren via TEM-Rohr-Stecker gemäß einem Ausführungsbeispiel der vorliegenden Erfindung;
- Fig. 50 und 51: eine isometrische Darstellung und eine Schnittteildarstellung für eine Verschaltung von TEM-Rohren via Leiter-Verbindunghülsen gemäß einem Ausführungsbeispiel der vorliegenden Erfindung:
- Fig. 52 bis 54: isometrische bzw. Schnittteildarstellungen für eine Verschaltung von TEM-Rohren mit einem Leiter-Stift gemäß einem Ausführungsbeispiel der vorliegenden Erfindung;
- Fig. 55: eine Schnittdarstellung für eine Anbindung eines TEM-Rohres über ein verlötetes Kabel gemäß einem Ausführungsbeispiel der vorliegenden Erfindung;
- Fig. 56: eine isometrische Darstellung eines TEM-Rohres mit einer durch Umformung hergestellten Rohr-Profilierung gemäß einem Ausführungsbeispiel der vorliegenden Erfindung; und
- Fig. 57 bis 59: eine isometrische Darstellung und eine Schnittdarstellung für ausgefüllte und/oder eine mit Blech bedeckte Umform-Rohrprofilierungen gemäß Ausführungsbeispielen der vorliegenden Erfindung.

In der nachfolgenden Beschreibung von günstigen Ausführungsbeispielen der vorliegenden Erfindung werden für die in den verschiedenen Zeichnungen dargestellten und ähnlich wirkenden Elemente gleiche oder ähnliche Bezugszeichen verwendet, wobei auf eine wiederholte Beschreibung dieser Elemente verzichtet wird.

Ein TEM-Rohr gemäß den hier vorgestellten Ausführungsbeispielen der Erfindung wird durch ein zweiwandiges Rechteckrohr gebildet, wobei TE-aktive Materialien in einem Zwischenraum
der beiden Wandungen eingebracht werden. Ein inneres Rohr des TEM-Rohrs steht in Kontakt mit einem von zwei einen TEG durchströmenden Fluiden, ein äußeres Rohr des TEM-Rohres steht in Kontakt mit dem anderen der zwei den TEG durchströmenden Fluiden.

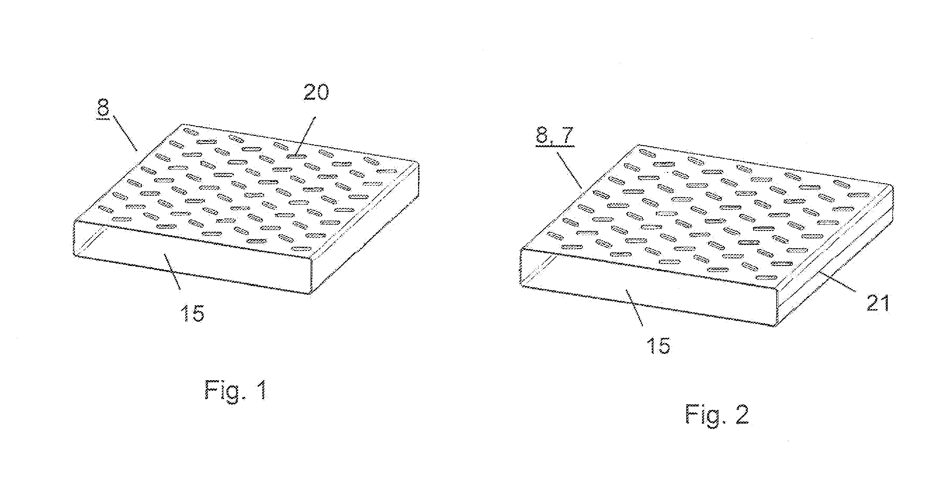

Verschiedene Ausführungsbeispiele für innere und/oder äußere Rohre des zweiwandigen Rechteckrohres sind in den Figuren 1 bis 9 gezeigt.
So zeigt Fig. 1 in einer isometrischen Darstellung ein einteiliges äußeres Rohr bzw. Außenflachrohr 8 zur Verwendung in einem TEG. In einem Inneren weist das Außenflachrohr 8 einen Nicht-Leiter 15 auf. Eine nach außen gerichtete Hauptfläche des Außenflachrohres 8 ist mit einer Profilierung 20 versehen.
Fig. 2 zeigt in einer weiteren isometrischen Darstellung ein ähnliches Ausführungsbeispiel eines profilierten einteiligen äußeren Rohres, 8wobei hier das Rohr 8 eine Naht 21 in einer Seitenfläche des Rohres 8 aufweist. Das in Fig. 2 gezeigte Rohr kann auch als ein Innenrohr 7 für ein zweiwandiges Rohr eingesetzt werden.

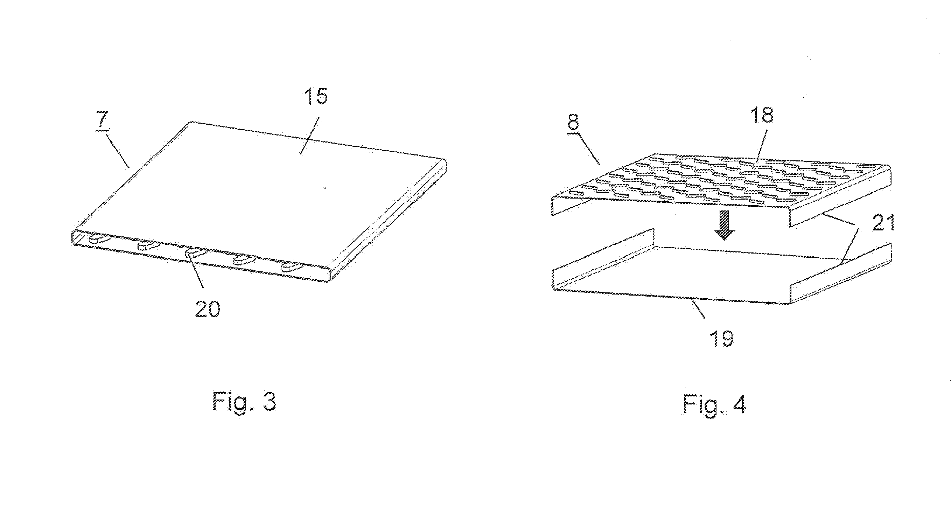

Fig. 3 zeigt in einer isometrischen Darstellung ein Ausführungsbeispiel eines einteiligen inneren Rohres 7 mit einem Nicht-Leiter 15 und einer Profilierung 20.

Das innere 7als auch das äußere Rohr 8ist im Wesentlichen aus einem metallischen Material, bevorzugt aus einem Edelstahl, z.B. 1.4404 gefertigt. Jedoch ist auch ein Aluminium- oder Kupferwerkstoff für niedrigere Einsatztemperaturen vorstellbar.

Die beiden Rohre 7, 8 sind zumindest auf ihren einem Zwischenraum zwischen den Rohren 7, 8 zugewandten Seiten teilweise oder ganz mit dem elektrisch nichtleitenden Material 15 überzogen, so dass TE-Material und Rohre 7, 8, bzw. elektrische Leiter und Rohre 7, 8zueinander elektrisch isoliert sind. Dieses nichtleitende Material 15 kann beispielsweise eine Keramik-Beschichtung oder eine Keramik-Folie 15sein. Das nichtleitende Material 15kann beispielsweise über einen Löt- oder Sinterprozess aufgebracht werden, wobei hierzu die Rohre 7, 8in unterschiedlicher Weise vorbehandelt sein können. Beispielsweise können die Rohre 7, 8 galvanisiert oder bedruckt sein, oder sie können auch mit einem zusätzlichen Überzug, z.B. aus Wolfram oder Silber, ausgestattet sein.

Das Außenrohr 8 und/oder das Innenrohr 7 können auf einer jeweiligen einem Fluid zugeordneten Seite die Profilierung 20 aufweisen. Bei den in den Figuren 1 bis 9 gezeigten Ausführungsbeispielen ist die Profilierung 20 in Form von länglichen Noppen ausgebildet. Die Profilierung 20 kann beispielsweise auch als eine Berippung, Kiemen, Winglets oder als eine Prägung ausgebildet sein. Durch die Profilierung 20 wird bewirkt, dass ein Wärmeübergang in einer Strömung des Fluids verbessert wird und/oder eine Wärmeübertragungsfläche vergrößert wird. Die Berippung 20kann auf unterschiedliche Weise herbeigeführt werden, z.B. durch Erodieren, Ätzen, Fräsen, Laserschmelzverfahren, Prägen, eine zusätzliche TE-Einlage oder Rippen.

Das Außenrohr 8und/oder das Innenrohr 7können jeweils ein- oder mehrteilig aufgebaut sein. Bei einem zweiteiligen Aufbau ist dann das Rohr aus einem Oberteil 18und einem Unterteil 19 in Form von z.B. zwei Halbschalen zusammengesetzt. Das Oberteil 18und das Unterteil 19weisen in einem seitlichen Bereich des Rohres, also auf einer kurzen Rohrwand-Seite, die Verbindungsnaht 21 auf.

Entsprechend zeigen Figuren 4 bis 7 in isometrischen Darstellungen Ausführungsbeispiele von zweiteiligen inneren 7 und äußeren 8 Rohren.

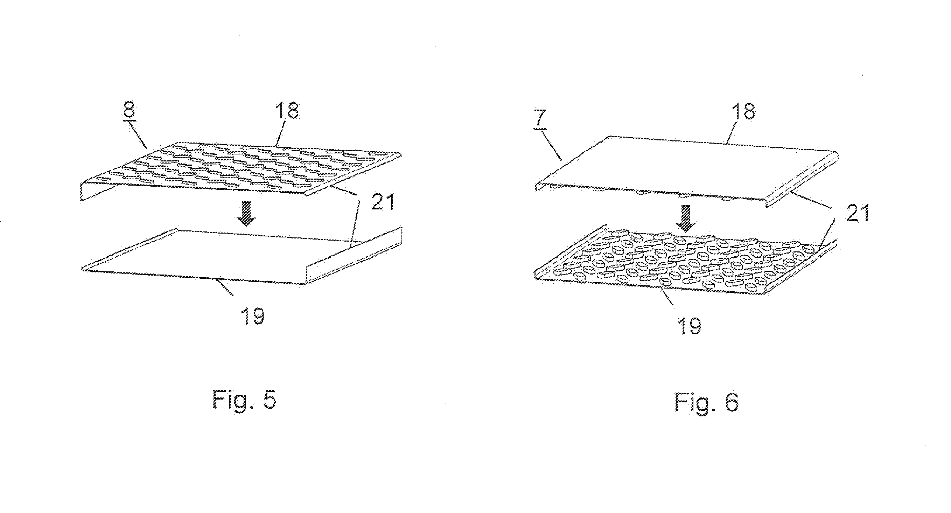

So zeigt Fig. 4 ein Ausführungsbeispiel eines zweiteiligen äußeren Rohres 8mit der Verbindungsnaht 21 im mittleren seitlichen Bereich und Fig. 5 ein Ausführungsbeispiel eines zweiteiligen äußeren Rohres 8mit der Verbindungsnaht 21 im oberen und/oder unteren seitlichen Bereich.

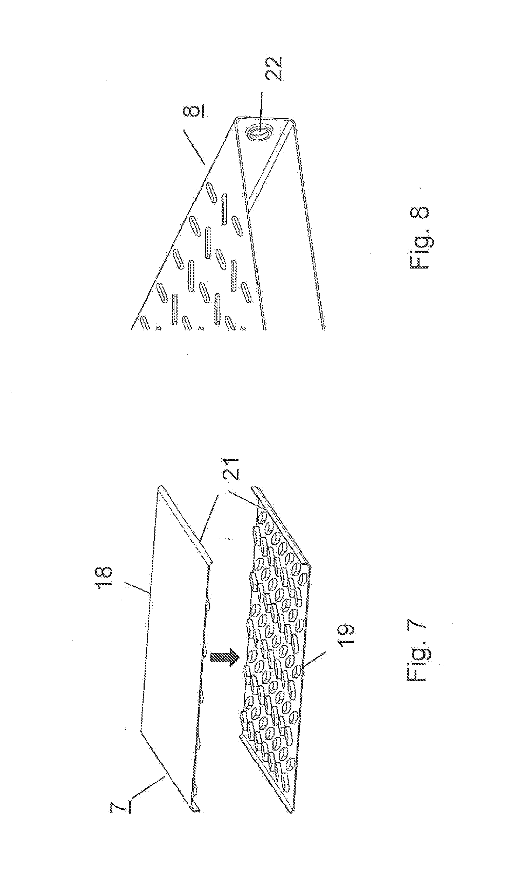

Fig. 6 zeigt ein Ausführungsbeispiel eines zweiteiligen inneren Rohres 7 mit der Verbindungsnaht 21 im mittleren seitlichen Bereich und Fig. 7 ein Ausführungsbeispiel eines zweiteiligen inneren Rohres 7 mit der Verbindungsnaht 21 im oberen und/oder unteren seitlichen Bereich.

Die Rohre 7, 8 können unabhängig davon, ob sie ein- oder mehrteilig hergestellt sind, die Nähte 21aufweisen.

Die Rohre 7, 8 können für eine elektrische Anbindung des TEM Öffnungen 22 aufweisen.

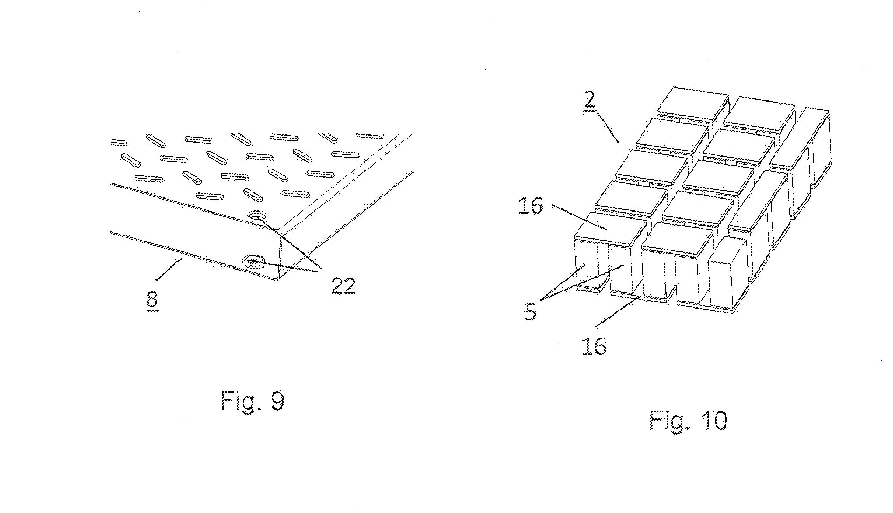

Entsprechend zeigt Fig. 8 in einer isometrischen Teildarstellung ein Ausführungsbeispiel eines äußeren Rohres 8 mit einer seitlichen Öffnung 22. Fig. 9 zeigt in einer isometrischen Teildarstellung ein Ausführungsbeispiel eines äußeren Rohres 8 mit einer unteren und/oder oberen Öffnung 22 in der unteren und/oder oberen Hauptfläche des Rohres 8.

Fig. 10 zeigt ein thermoelektrisches Modul (TEM) 2 in einer isometrischen Darstellung. Das TEM 2 setzt sich aus einer Mehrzahl von thermoelektrisch aktiven (TE-aktiven) Materialien 5 und Leitern 16 zusammen. Die TE-aktiven Materialien 5 sind in einer Ebene beabstandet voneinander angeordnet. Jeder Leiter 16 ist mit jeweils einer Unter- und/oder Oberseite von zwei TE-aktiven Materialien 5 verbunden. Die Leiter 16 können beispielsweise dünnwandige Kupferbleche sein.

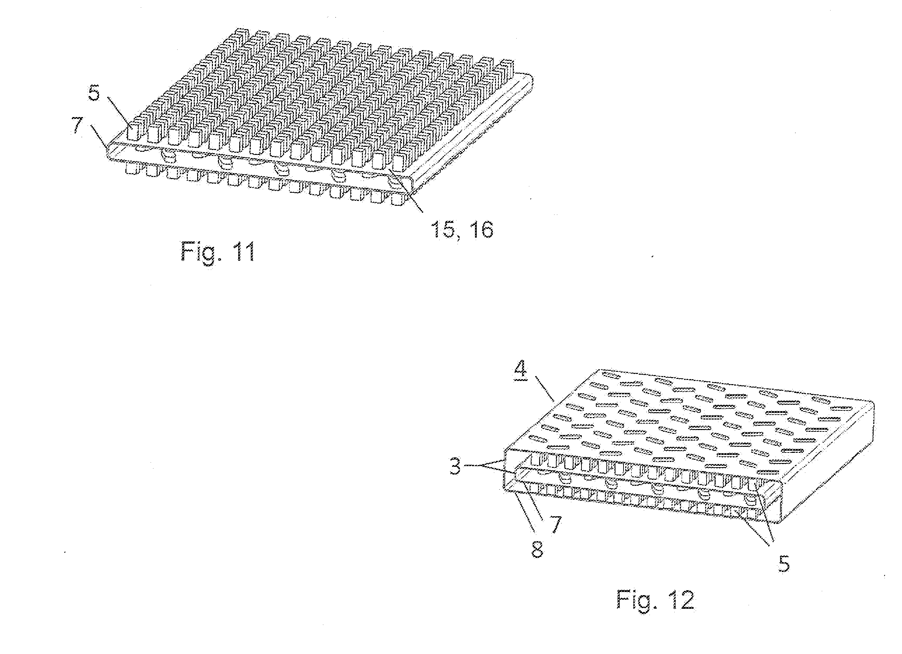

Fig. 11 zeigt isometrisch ein inneres Rohr 7, das an beiden Hauptflächen außenseitig 6 mit TE-Materialien 5 bestückt ist. Das Rohr 7 ist mit einem Nicht-Leiter 15 aus einem elektrisch nicht leitenden keramischen Material beschichtet. Die Leiter 16 sind mit der Keramik-Beschichtung 15 verbunden, z. B. durch Löten oder Sintern.

Fig. 12 zeigt in einer weiteren isometrischen Darstellung ein komplettes TEM-Rohr 4. Hier ist das im Zusammenhang mit Fig. 11 erläuterte mit TE-aktiven Materialien 5 bestückte innere Rohr 7 von dem äußeren Rohr 8 eingefasst. Das TEM-Rohr 4 setzt sich somit aus dem TEM und einem zweiwandigen Rohr 3 aus dem Innenrohr 7 und dem Außenrohr 8 zusammen. Das zweiwandige Rechteckrohr (3) oder Flachrohr (3) kann, wie bei dem in Fig. 12 gezeigten Ausführungsbeispiel, abgerundete Ecken aufweisen.

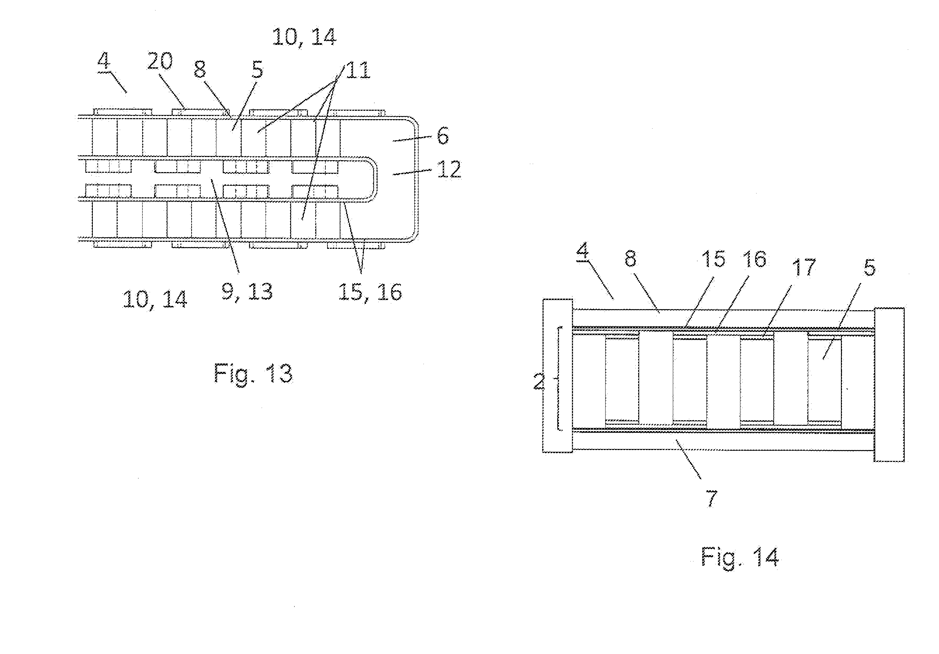

In Fig. 13 ist ein Ausschnitt des TEM-Rohres 4 aus Fig. 12 im Schnitt zu sehen. Gezeigt sind die TE-aktiven Materialien 5, der Zwischenraum 6 zwischen den zwei Wänden des TEM-Rohres 4, das äußere Rohr 8, ein erstes Fluid 9 (nicht dargestellt), ein zweites Fluid 10 (nicht dargestellt), obere und/oder ebene Spalten 11 des Zwischenraums, ein seitlicher Bereich 12 des Zwischenraums, ein innerer Bereich 13 für das erste Fluid 9, ein äußerer Bereich 14 für das zweite Fluid 10, das elektrisch nicht leitende Material 15, das elektrisch leitende Material 16 sowie die Profilierung 20 auf dem Außenrohr 8.

Die TE-Materialien 5befinden sich sowohl im oberen und als auch im unteren, ebenen Spalt des Zwischenbereichs 11, also an der langen Rohrwand-Seite des TEM-Rohrs 4, aber nicht im seitlichen Bereich 12, der sich an der kurzen Rohrwand-Seite befindet. Insofern besteht das TEM-Rohr 4 im Wesentlichen aus zwei planaren TEM bzw. TEM-Modulen 2, die sich parallel gegenüber stehen und den dazwischen liegenden Innenraum 13 schaffen, der das erste 9 der beiden Fluide 9, 10 aufnimmt und nach außen hin seitlich abgegrenzt ist. Der Zwischenraum des seitlichen Bereichs 12 kann eine thermische Trennung zwischen Innen 13 und Außen 14 darstellen. Der Zwischenraum 6 kann zusätzlich mit einem inerten Gas oder mit einem nicht leitenden Material ausgefüllt sein, um die TE-Materialien 5 zu schützen. Das nicht leitende Material kann beispielsweise von einem Kunststoff, einem Kleber, z.B. auf Sitikonbasis oder einer Keramik gebildet werden.

Fig. 14 zeigt in einer weiteren Darstellung im Querschnitt einen vergrößerten Ausschnitt des TEM-Rohres 4.

Die Leiter 16 sind mit den TE-Materialen 5 z. B. durch Löten verbunden und verschalten diese somit parallel und/oder seriell elektrisch miteinander. Zwischen einem Leiter 16 und einem eigentlichen TE-Material 5 kann noch eine Barriere-Schicht 17 eingebracht sein, welche die TE-Materialien 5, bzw. eine Dotierung der TE-Materialien 5 im Gebrauch schützt.

Die axialen Enden der TEM-Rohre 4 können bezüglich des Zwischenraums 6 abgeschlossen sein, so dass weder das erste Fluid 9 noch das zweite Fluid 10 in den Zwischenraum 6 eindringen können und das TEM 2 eingekapselt ist. Dies kann über einen TEM-Rohr-Deckel 23 bewerkstelligt werden, welcher den Zwischenraum 6 axial schließt.

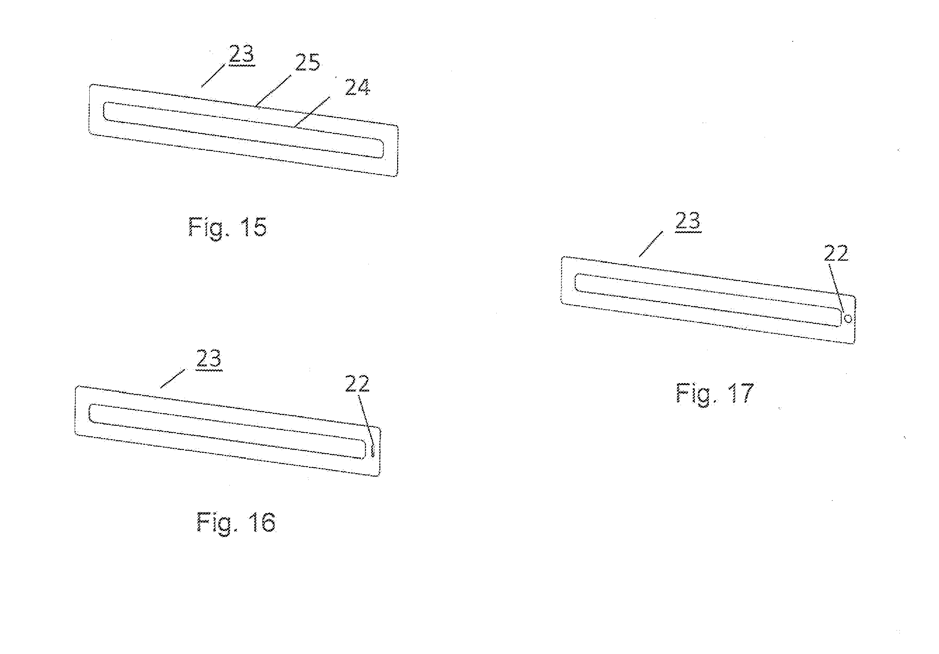

Entsprechend zeigen Figuren 15 bis 17 isometrische Darstellungen von beispielhaften TEM-Rohr-Deckeln 23. Der TEM-Rohr-Deckel 23 weist eine Innenkontur 24 und eine Außenkontur 25 auf. Der TEM-Rohr-Deckel 23 kann für die elektrische Anbindung des TEM 2 Öffnungen 22 aufweisen, wie aus den in Figuren 16 und 17 gezeigten Ausführungsbeispielen ersichtlich ist.

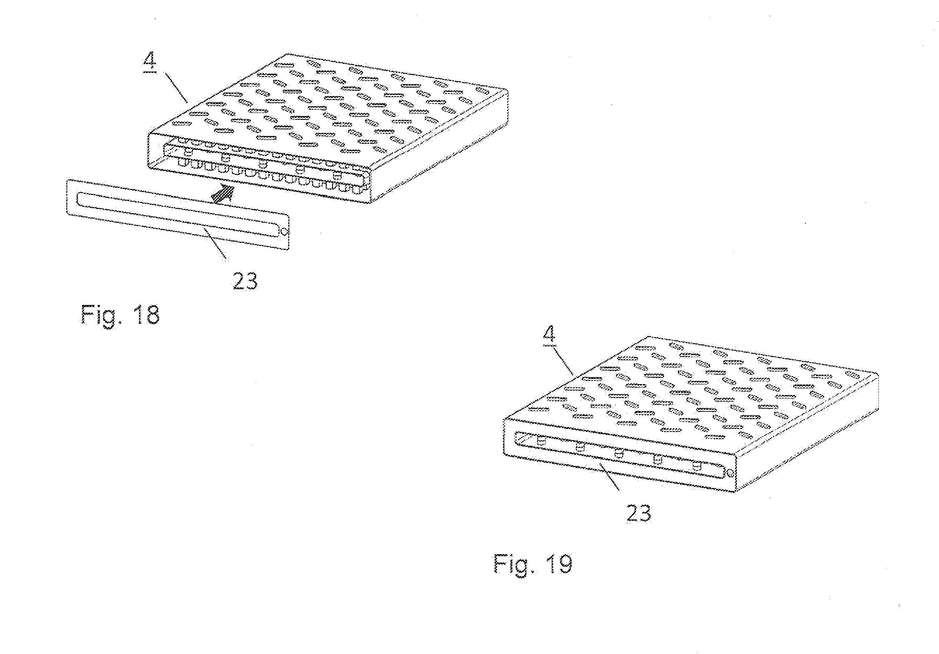

Fig. 18 und 19 zeigen beispielhaft ein Fügen des TEM-Rohr-Deckels 23 mit dem TEM-Rohr 4 bzw. das TEM-Rohr 4 mit gefügtem Deckel 23.

Dabei ist die Innenkontur 24 des TEM-Rohr-Deckels 23 mit dem Innenrohr 7 verbunden, und die Außenkontur 25 des TEM-Rohr-Deckels 23 ist mit dem Außenrohr 8 verbunden. Der Deckel 23 gewährleistet somit eine ungehinderte Beströmung des Innenraums 13 und des Außenraums 14 des TEM-Rohres 4. Der Deckel 23 kann bündig mit dem Rohr 3 abschließen oder bezüglich des Innenrohres 7 zurückstehen, wenn das Außenrohr 8 kürzer als das Innenrohr 7 ist. Der TEM-Rohr-Deckel 23 kann zu den elektrischen Komponenten 16, 5 des TEM-Rohres 4 isoliert sein.

Fertigungstechnisch kann zunächst das Innenrohr 7 mit dem TEM 2 beidseitig bestückt und anschließend das Außenrohr 8 hinzugefügt werden. Gefügtes Außenrohr 8, TEM 2, Innenrohr 7 und ggf. auch der TEM-Rohr-Deckel 23 können anschließend einer Wärmebehandlung, z.B. einer Ofenlötung, unterzogen werden, so dass die Komponenten miteinander verbunden werden.

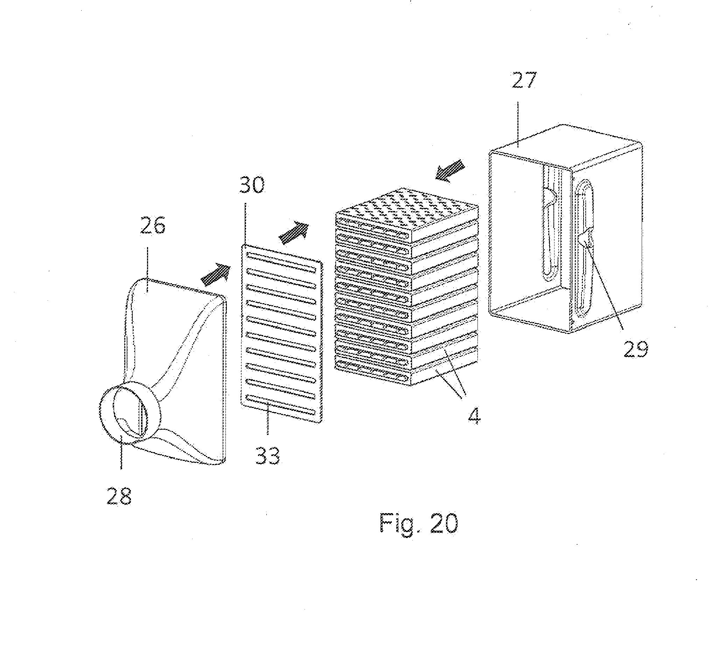

Fig. 20 zeigt in einer isometrischen Explosionsdarstellung beispielhaft eine Zusammensetzung der einzelnen Komponenten eines thermoelektrischen Generators (TEG). Gezeigt sind eine Mehrzahl von TEM-Rohren 4, ein Diffusor 26 für das erste Fluid, ein Gehäuse 27 für das zweite Fluid, eine Öffnung 28 in dem Diffusor 26, eine Öffnung 29 in dem Gehäuse 27 sowie ein Boden 30 mit Öffnungen 33.

Der TEG besteht im Kern aus einer Mehrzahl übereinander gestapelter TEM-Rohre 4, sowie Böden 30, Diffusoren 26, einem Gehäuse 27und diversen elektronischen Komponenten, wie z.B. Leitungen und/oder Stecker, welche den TEG sowohl nach außen hin elektronisch anbinden als auch ggf. die TEM-Rohre 4 untereinander seriell oder parallel verschalten. Für die elektrische Anbindung des TEG sind die Diffusoren 26 und/oder das Gehäuse 27 mit diesbezüglichen Öffnungen ausgeführt. Der Übersichtlichkeit halber ist der in Fig. 20 isometrisch dargestellte TEG mit lediglich einem Boden 30 und einem Diffusor 26 gezeigt. Ebenso ist nur eine der Öffnungen 33 und 29 mit einem Bezugszeichen versehen. Die elektronischen Komponenten sind nicht gezeigt.

Aus Fig. 20 ist ersichtlich, dass die TEM-Rohre 4 zueinander beabstandet sind und sich insofern gegenseitig nicht berühren. Die TEM-Rohre 4 sind mit den Öffnungen 33 der Böden 30 verbunden. Die Form der Öffnungen 33 der Böden 30 ist so gestaltet, dass sie einem Innenrohrquerschnitt der der TEM-Rohre 4 entspricht. Die Böden 30 sind mit dem Gehäuse 27 und/oder den Diffusoren 26 verbunden. Das Gehäuse 27 und die Diffusoren 26 können miteinander verbunden sein.

Dem in Fig. 20 gezeigten exemplarischen TEG kann das erste Fluid über die Öffnung 28 in dem Diffusor 26 zugeführt werden. Anschließend kann es in die Innenräume der TEM-Rohre 4 geleitet werden. Danach kann das erste Fluid in den zweiten Diffusor 26 gelangen und abschließend über dessen Öffnung 28 hinausgeführt werden. Das zweite Fluid kann über die Öffnung 29 in dem Gehäuse 27 mit dem TEG kommunizieren. Das zweite Fluid kann in dem Gehäuse 27 den zusammenhängenden Außenraum der TEM-Rohre 4 umströmen und über die gegenüberliegende Öffnung 29 in dem Gehäuse 27 wieder hinausgeführt werden.

Die Böden 30 trennen einen Bereich des ersten Fluids in dem TEG von einem Bereich des zweiten Fluids.

In Fig. 20 nicht gezeigt ist, dass die elektrische Anbindung der TEM-Rohre wie bereits erläutert 4über Öffnungen des seitlichen Bereichs der TEM-Rohre und/oder über Öffnungen des oberen und unteren Bereichs der TEM-Rohre oder in axiale Richtung erfolgen kann. In diesem Falle kann dies auch über die TEM-Rohr-Deckel erfolgen.

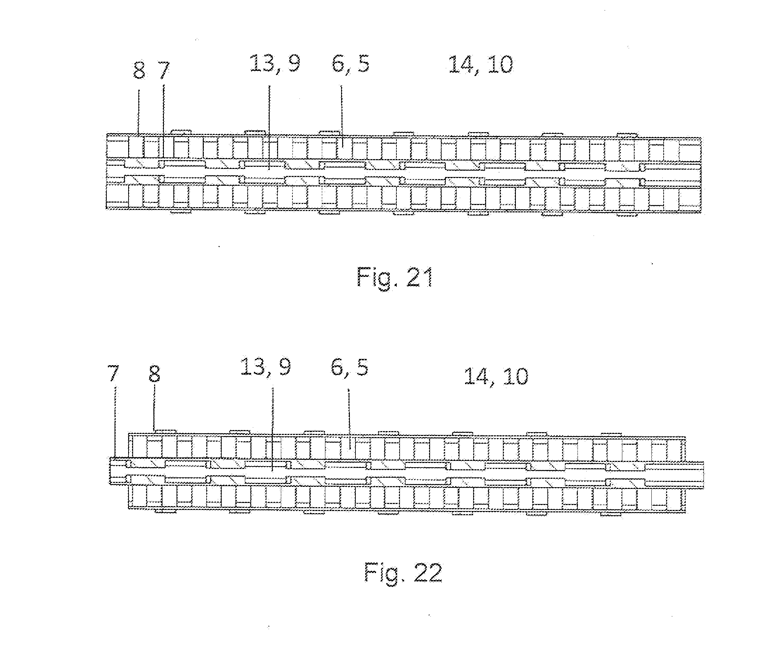

Das Innenrohr des TEM-Rohres kann mit dem Außenrohr bündig sein. Das Außenrohr kann gegenüber dem Innenrohr auch zurückstehen. Entsprechende Ausführungsbeispiele sind in den Figuren 21 und 22 illustriert, die jeweils einen Längsschnitt durch ein inneres 7 und äußeres 8 Rohr eines beispielhaften TEM-Rohres zeigen.

So zeigt die Schnittdarstellung des Ausführungsbeispiels in Fig. 21, dass inneres 7 und äußeres 8 Rohr in Längsrichtung bündig angeordnet sind. Dagegen steht bei dem in Fig. 22 gezeigten Ausführungsbeispiel das innere Rohr 7 in Längsrichtung gegenüber dem äußeren Rohr 8 vor.

Je nachdem, wie Außenrohr und Innenrohr gestaltet sind, und ob ein TEM-Rohr-Deckel Verwendung findet, und auch in welcher Weise die elektrische Anbindung der TEM-Rohre vollzogen wird, kommt ein Innenrohr-Boden und/oder ein Außenrohr-Boden zum Einsatz.

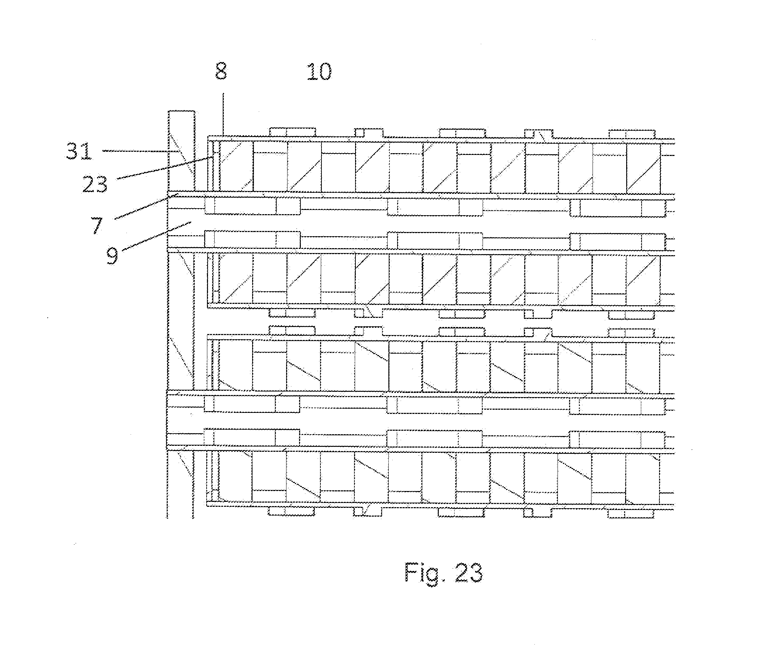

Entsprechend zeigen Figuren 23 bis 27 unterschiedliche Ausführungsbeispiele von Böden 30, die entsprechend der Anordnung von Innerohr 7 zu Außenrohr 8 als ein Innenrohr-Boden 31 und/oder ein Außenrohr-Boden 32 ausgebildet sind.

Fig. 23 zeigt in einer Schnittdarstellung eine Ausführung des Bodens als Innenrohr-Boden 31 in Verbindung mit zwei gegenüber den Außenrohren 8 vorstehenden Innenrohren 7. Die TEM-Rohre sind mit Deckeln 23 versehen. Der Innenrohr-Boden 31 ist von den Außenrohren 8 beabstandet und über seine Öffnungen mit den Innenrohren 7 verbunden. Der Innenrohr-Boden 31 trennt das erste Fluid 9und das zweite Fluid 10.

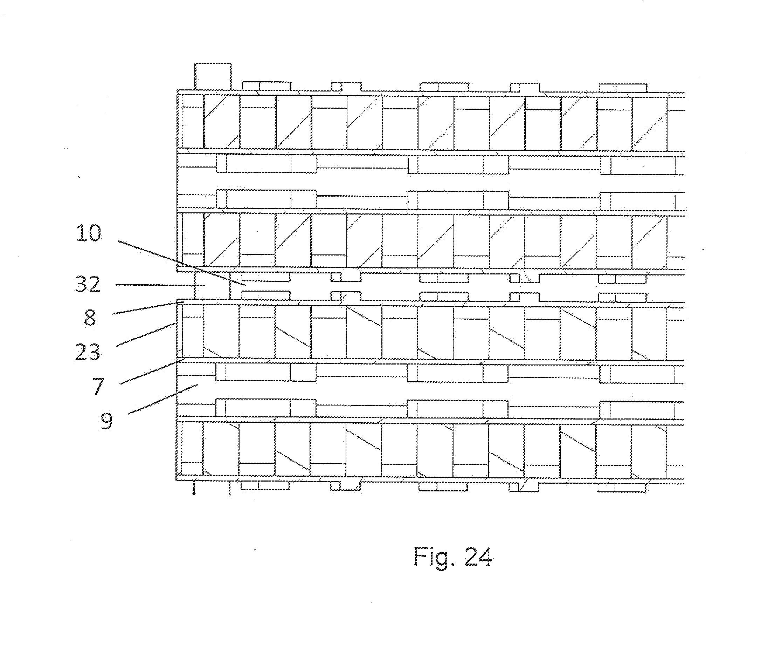

Fig. 24 zeigt in einer Schnittdarstellung eine Ausführung des Bodens als Außenrohr-Boden 32 in Verbindung mit zwei gegenüber den Innenrohren 7 fluchtend angeordneten Außenrohren 8. Die TEM-Rohre sind hier wiederum mit Deckeln 23 versehen. Der Außenrohr-Boden 32 kann über dessen Öffnungen 33 mit den Außenrohren 8 verbunden werden und trennt das erste Fluid 9 und das zweite Fluid 10.

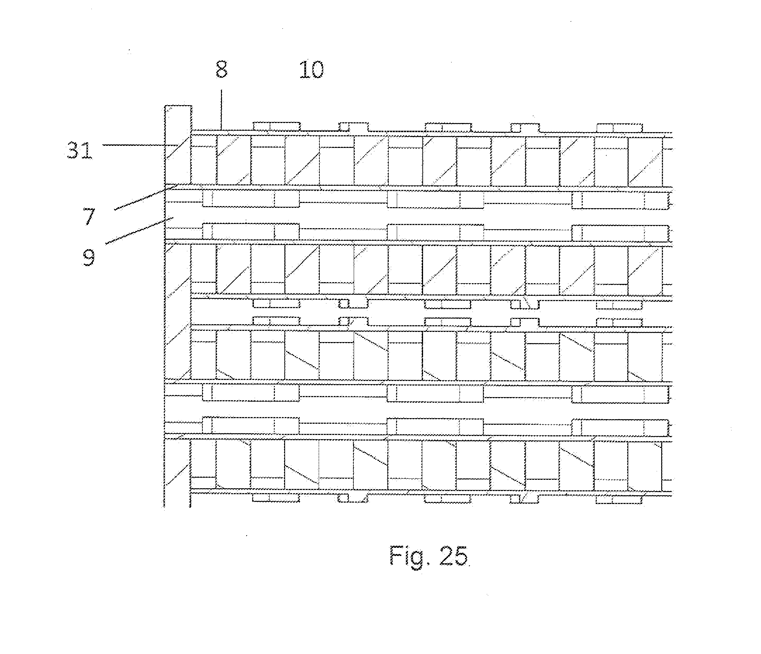

Fig. 25 zeigt in einer Schnittdarstellung eine weitere Ausführung des Bodens als Innenrohr-Boden 31 in Verbindung mit zwei gegenüber den Außenrohren 8 vorstehenden Innenrohren 7. Aufgrund der nicht vorhandenen Beabstandung zwischen dem Innenrohr-Boden 31 und den Außenrohren 8 ist der InnenrohrBoden 31 auch mit dem Außenrohr 8 verbunden. Somit kann entsprechend dieser Ausführung auf Deckel 23 verzichtet werden. Wiederum trennt der Innenrohr-Boden 31 das erste Fluid 9 von dem zweiten Fluid 10.

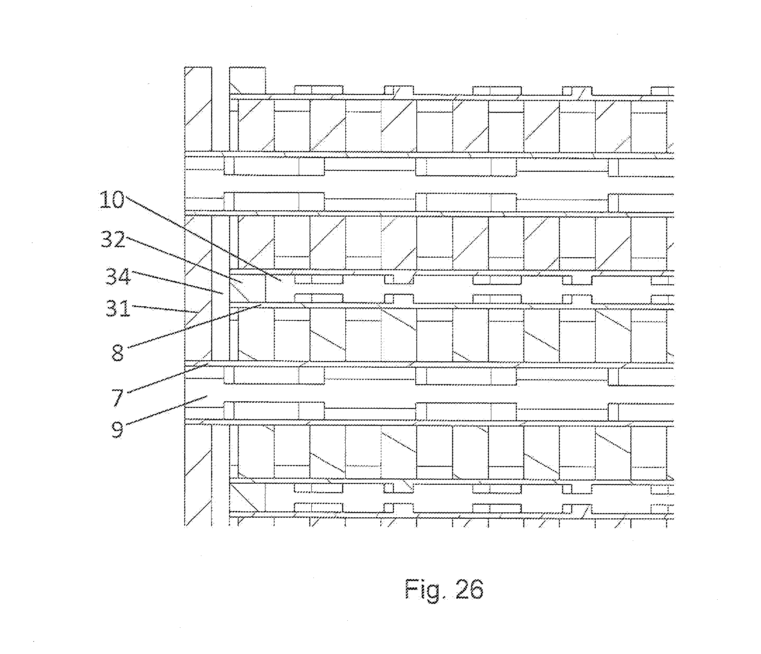

Fig. 26 zeigt ein Ausführungsbeispiel mit Einsatz sowohl eines InnenrohrBodens 31 als auch eines Außenrohr-Bodens 32. Kommen sowohl der Außenrohr-Boden 32als als auch der Innenrohr-Boden 31 zum Einsatz, wird zwischen diesen beiden Böden 31 und 32 ein Zwischenraum 34gebildet, der weder das erste Fluid 9noch das zweite Fluid 10 aufnimmt. Dieser Zwischenraum 34 eignet sich beispielsweise für die elektrische Anbindung der TEM-Rohre und/oder des TEGs. Diese in Fig. 26 gezeigte Ausführung ist sowohl mit als auch ohne Deckel 23 realisierbar.

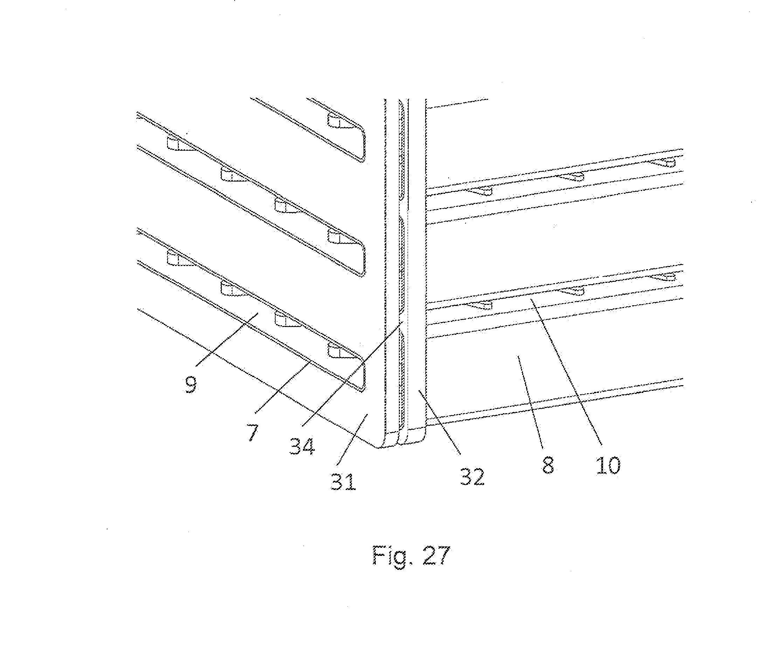

Fig. 27 zeigt das im Zusammenhang mit Fig. 26 erläuterte Ausführungsbeispiel zur besseren Verständlichkeit nochmals in einer isometrischen Darstellung. Hier ist der durch den Innenrohr-Boden 31 und den Außenrohr-Boden 32 gebildete nicht durchströmte Zwischenraum 34 deutlich zu erkennen.

Im Folgenden werden die verschiedenen Möglichkeiten einer elektrischen Verbindung von einzelnen thermoelektrischen Modulen erläutert.

Generell können die TE-aktive Materialien bzw. thermoelektrischen Module im unteren und oberen Spalt des Zwischenbereichs in einem TEM-Rohr untereinander seriell und/oder parallel verschaltet sein. Die TE-aktiven Materialien des unteren Spalts des Zwischenbereichs können mit den TE-aktiven Materialien des oberen Spalts des Zwischenbereichs seriell oder parallel verschaltet sein. Die TEM-Rohre können untereinander seriell und/oder parallel verschaltet sein. Die elektrisch leitenden Verbindungen außerhalb der TEM-Rohre, welche in Kontakt mit ersten Fluid und/oder dem zweiten Fluid stehen, müssen ggf. elektrisch isoliert sein. Die elektrische Anbindung kann im Bereich des ersten Fluids, des zweiten Fluids oder im neutralen Bereich des Boden-Zwischenraums zwischen einem Außenrohr-Boden und einem Innenrohr-Boden erfolgen. Die elektrische Anbindung kann kraft-, form-, oder stoffschlüssig sein.

Die TE-Materialien des oberen und unteren Bereichs des Zwischenbereichs können über deren Leiter und einen Leiterverbinder miteinander elektrisch verbunden sein. Gegebenenfalls kann dies auch über Einsteckleiter oder Einsteckbuchsen realisiert werden. Die Leiterverbinder sind in bevorzugter Weise ein dünnwandiges Kupferblech.

Nachfolgend sind verschiedene Ausführungen der elektrischen Anbindung, welche untereinander kombinierbar sind, ausführlicher erläutert.

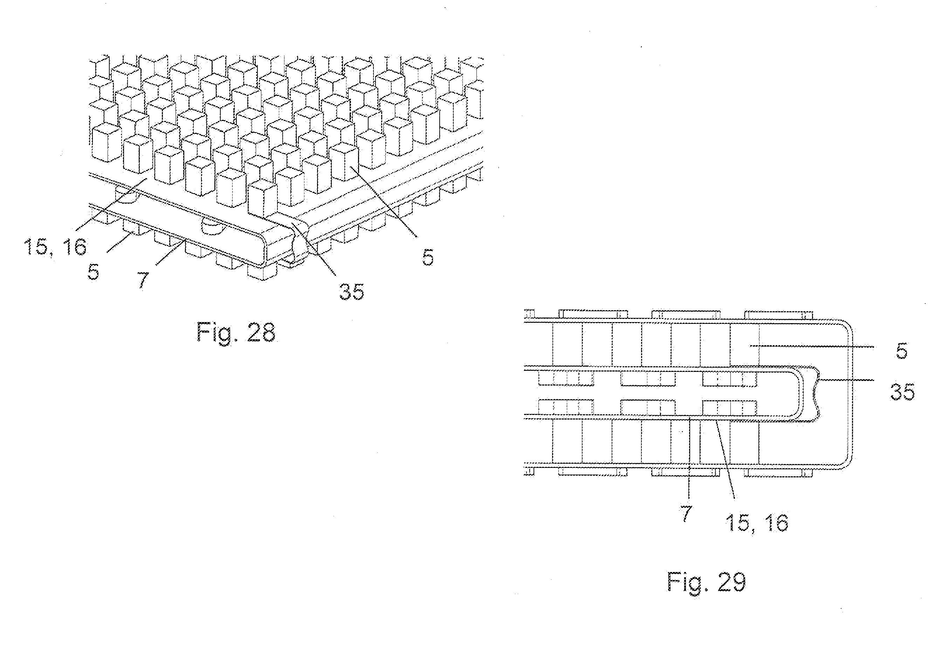

Die nachfolgenden Figuren 28 bis 45 zeigen unterschiedliche Ausführungsbeispiele von Leiterverbindern und deren Anschlussmöglichkeiten.

So zeigt Fig. 28 in einer isometrischen Darstellung einen Ausschnitt eines beispielhaften inneren Rohres 7, das an sich gegenüberliegenden Hauptflächen mit TE-aktiven Materialien 5 bestückt ist. In ihrer Gesamtheit bilden die auf einer Hauptfläche benachbart angeordneten TE-aktiven Materialien 5 das thermoelektrische Modul 2. In Fig. 28 ist eine Leiterverbindung 35 des oberen und unteren Spalts des Zwischenbereichs gezeigt. Das obere und das untere thermoelektrische Modul 5 eines TEM-Rohres sind somit elektrisch leitfähig miteinander verbunden. Wie es in Fig. 28 gezeigt ist, kann der Leiterverbinder 35 teilweise von dem Innenrohr 7 abstehen und ist immer zum Innenrohr 7 elektrisch isoliert 15.

Deutlicher ist dies anhand der in Fig. 29 gezeigten Schnittdarstellung des Ausschnitts des TEM-Rohres aus Fig. 28 zu erkennen. Die Leiterverbindung 35 des oberen und unteren Spalts des Zwischenbereichs 11 steht im seitlichen Bereich des Zwischenbereichs ab.

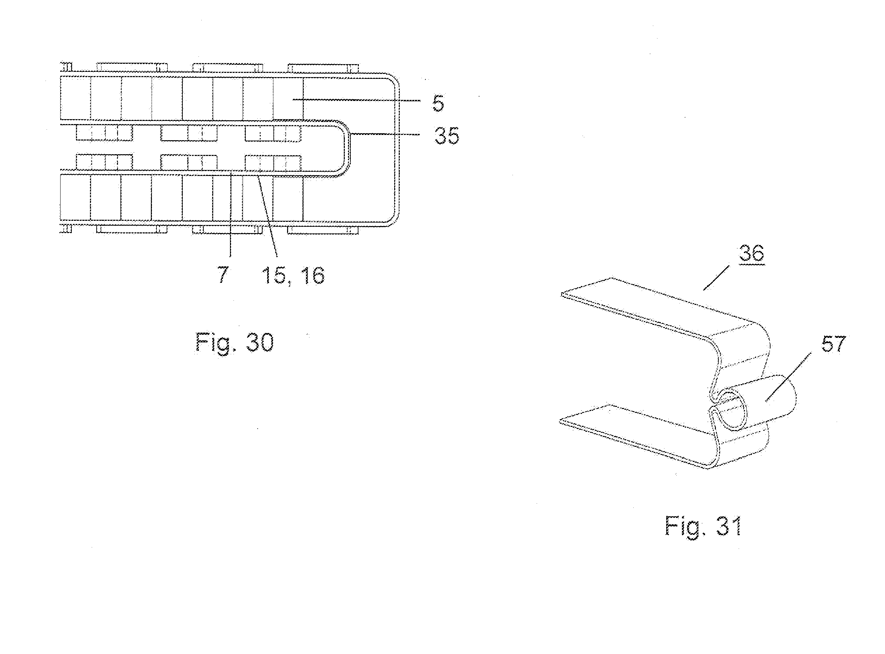

Im Gegensatz dazu zeigt die Teilschnittdarstellung in Fig. 30 ein Ausführungsbeispiel der Leiterverbindung 35 des oberen und unteren Spalts des Zwischenbereichs 11, das ganzflächig mit Innenrohr 7 verbunden ist.

Der Leiterverbinder kann zudem eine Buchse aufweisen, wie das anhand der isometrischen Darstellung eines Ausführungsbeispiels eines Leiterverbinders 36 in Fig. 31 illustriert ist. Eine Buchse 57 dient hier als elektrisches Anschlusselement, um das TEM-Rohr über Leitungen, Kabel, Stecker oder ähnliches extern elektrisch anzubinden. Die Buchse 57 kann einen konischen Verlauf haben oder Einrastelemente oder Widerhaken oder Klemmen besitzen, um ein Lösen einer Leitung oder eines Steckers zu unterbinden.

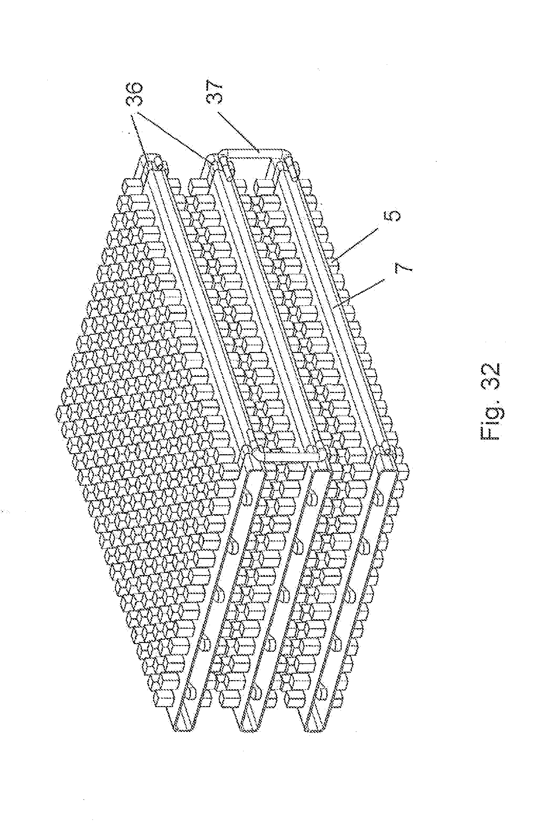

Fig. 32 zeigt in einer isometrischen Darstellung eine Verschaltungsmöglichkeit von TEM-Rohren über Leiterverbindungen 36 mit Buchse 57. Bei dem in Fig. 32 gezeigten Ausführungsbeispiel sind elektrische Leitungen 37, beispielsweise elektrisch isolierte Kupferkabel, durch Buchsen 57 der Leiterverbindungen 36 geführt, um so drei aufeinander gestapelte TEM-Rohre elektrisch miteinander zu verbinden. Die TEM-Rohre sind in Fig. 32 ohne Außenrohre dargestellt. Es können auch mehr oder weniger als die dargestellten drei TEM-Rohre verbunden werden. Die Leiterverbindung 36 mit Buchse 37 erfüllt somit also die doppelte Funktion, sowohl die TE-Module ein und desselben TEM-Rohres als auch eine Mehrzahl von TEM-Rohren elektrisch zu verschalten.

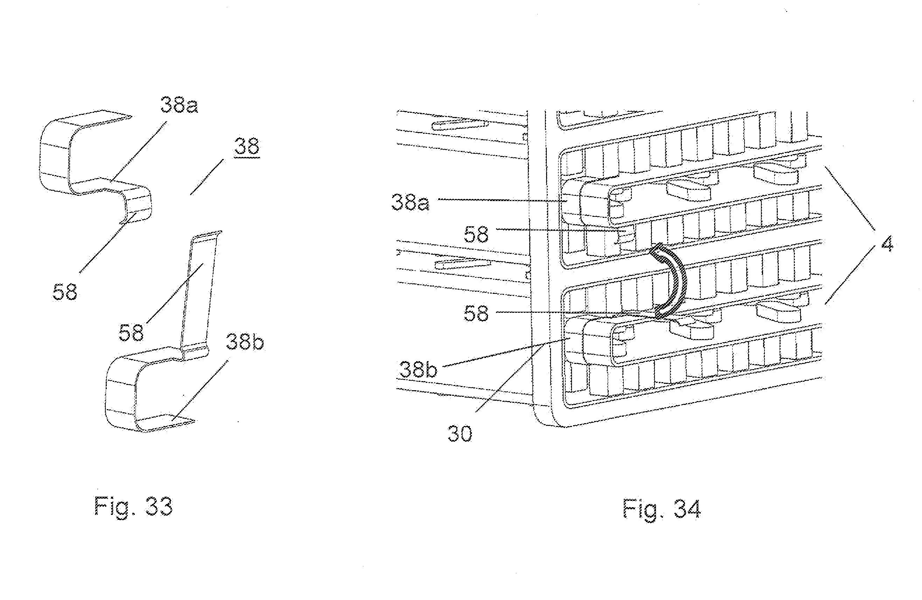

Die isometrische Darstellung in Fig. 33 zeigt ein Ausführungsbeispiel eines Leiterverbinders 38 in zwei-teiliger Form. Diese zweiteilige TEM-Rohr-TEM-RohrLeiterverbindung 38 ist ausgebildet, um zwei TEM-Rohre miteinander elektrisch zu verschalten und besitzt diesbezüglich zusätzliche Ausprägungen 58, die einen ersten Teil 38a und einen zweiten Teil 38b der Leiterverbindung 38 miteinander verbinden lassen.

Entsprechend zeigt Fig. 34 einen Einsatz der beispielhaften Leiterverbindung 38 in einer isometrischen Teildarstellung. Beide Teile 38a und 38b sind auf je ein Innenrohr von zwei TEM-Rohren 4 gesteckt. Ein Pfeil deutet einen Arbeitsschritt zum Fügen der Teile 38a und 38b mittels der Ausprägungen 58 beider Teile 38a, 38b, um so die elektrische Verschaltung der TEM-Rohre 4 herzustellen.

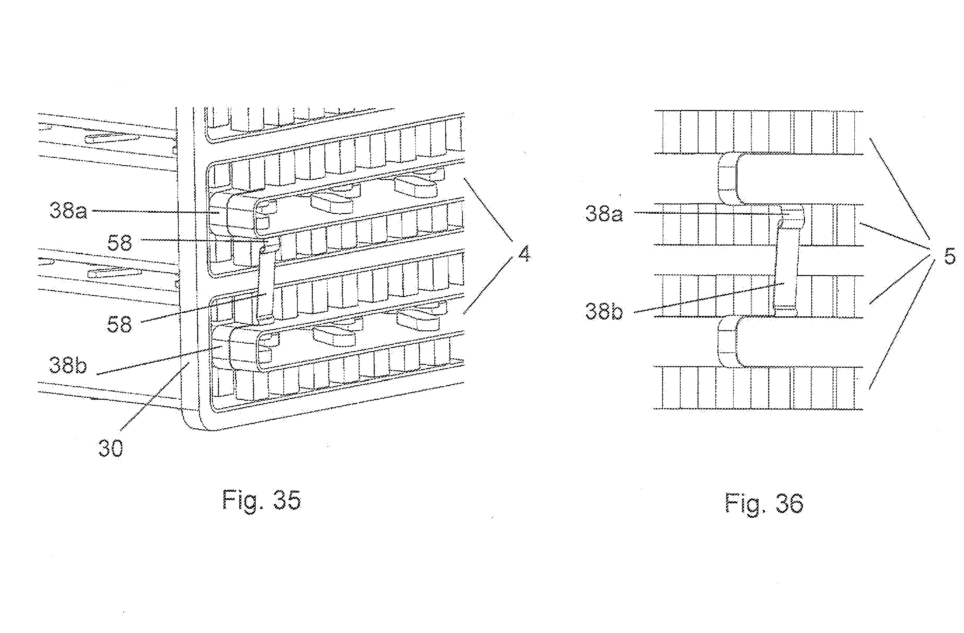

Fig. 35 zeigt in einer isometrischen Darstellung einen Zustand nach abgeschlossenem Arbeitsschritt gemäß der Darstellung in Fig. 34. Gezeigt sind zwei mittels der zwei-teiligen TEM-Rohr-TEM-Rohr-Leiterverbindung 38 verschaltete TEM-Rohre 4. Die zwei-teilige TEM-Rohr-TEM-Rohr-Leiterverbindung 38 ist zur elektrischen Verschaltung von TEM-Rohren mit gegenüber den Außenrohren vorstehenden Innenrohren geeignet.

Zur Verdeutlichung zeigt die Darstellung in Fig. 36 nochmals in vergrößerter Ansicht die Funktionalität des zweiteiligen Verbinders 38 zum Verschalten von TEMs.

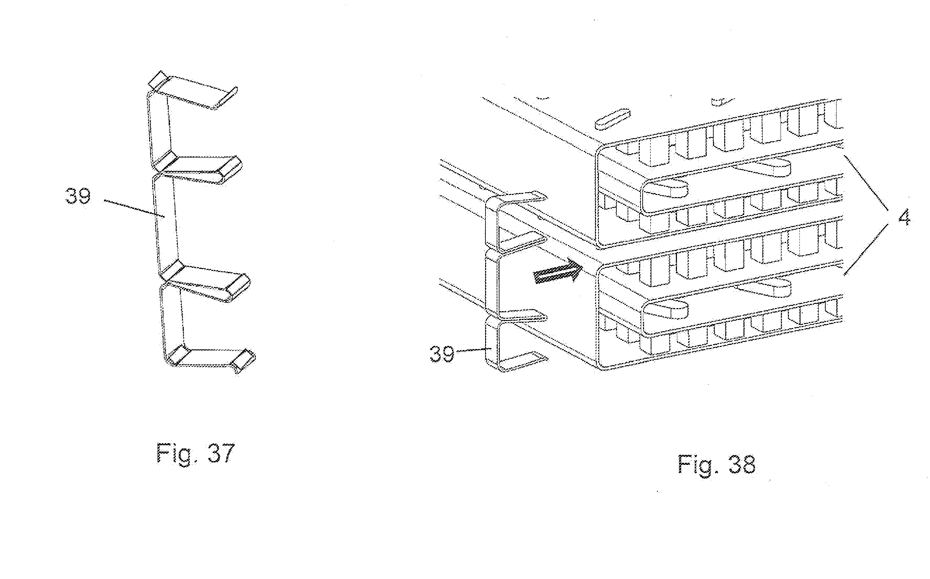

Fig. 37 zeigt in einer isometrischen Darstellung eine einteilige TEM-Rohr-TEMRohr-Leiterverbindung 39.

Ein Arbeitsschritt zum Einsatz der TEM-Rohr-TEM-Rohr-Leiterverbindung 39 ist anhand der isometrischen Darstellung in Fig. 38 gezeigt. Der Leiterverbinder 39 kann in einteiliger Form zwei TEM-Rohre 4 elektrisch miteinander verschalten und ist ähnlicher einer Klammer gestaltet.

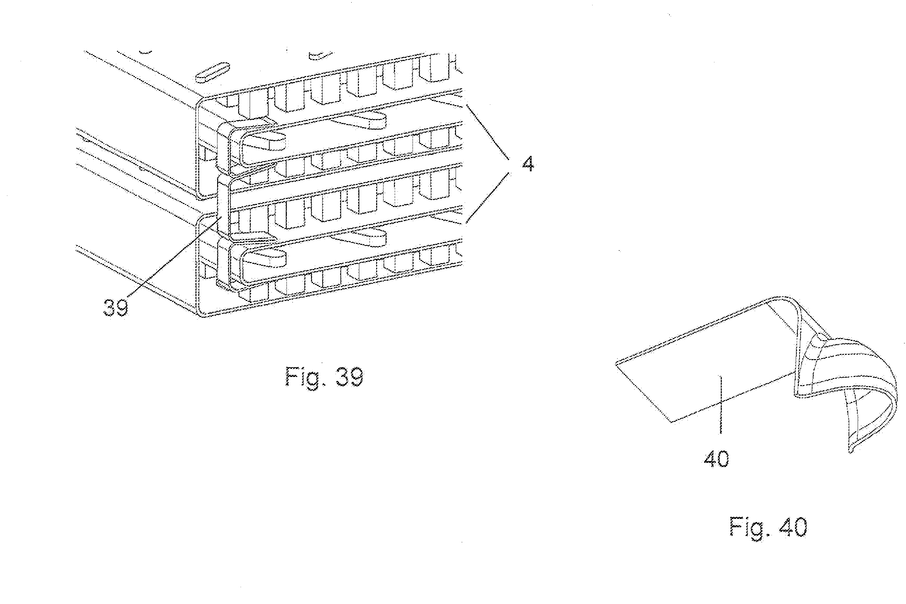

Fig. 39 zeigt entsprechend in einer isometrischen Darstellung die gefügte einteilige TEM-Rohr-TEM-Rohr-Leiterverbindung 39. Auch der elektrische Verbinder 39 ist zur elektrischen Verschaltung von TEM-Rohren mit gegenüber den Außenrohren vorstehenden Innenrohren geeignet.

Figuren 40 bis 45 zeigen in isometrischen Darstellungen weitere Ausführungsmöglichkeiten des hier vorgeschlagenen elektrischen Verbinders zur Verschaltung von thermoelektrischen Modulen sowie deren Einsatzpositionen an TEM-Rohren.

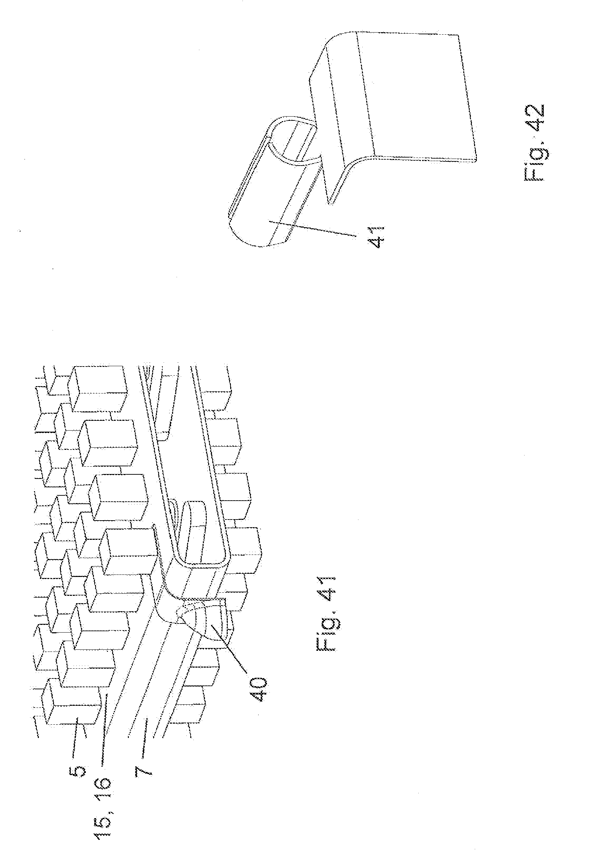

So zeigen Figuren 40 und 41 ein Ausführungsbeispiel eines Einsteckleiters 40 bzw. den Einsteckleiter 40 in Verbindung mit thermoelektrischen Modulen eines TEM-Rohres.

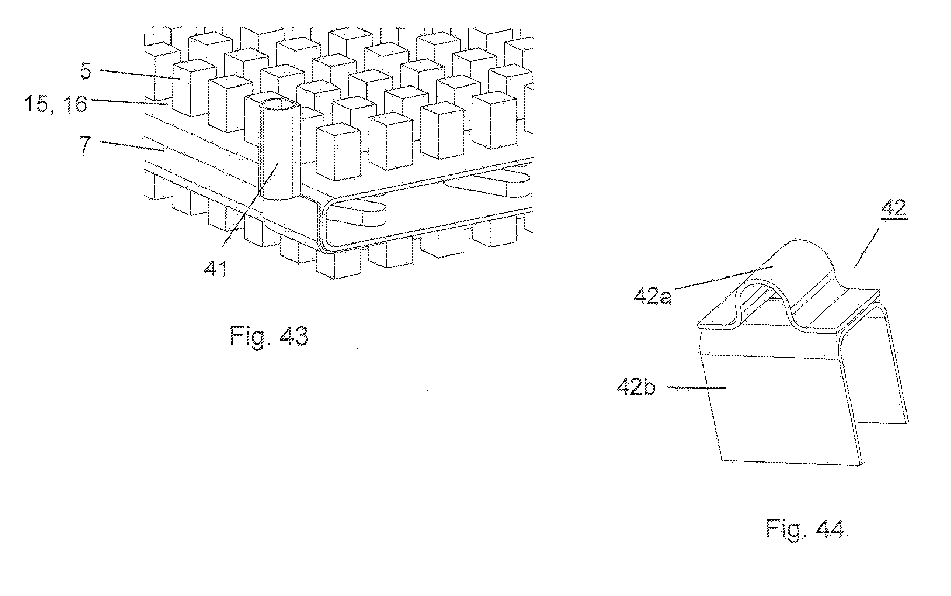

Figuren 42 und 43 zeigen ein Ausführungsbeispiel einer Einsteckbuchse 41 bzw. die Einsteckbuchse 41 in Verbindung mit thermoelektrischen Modulen eines TEM-Rohres.

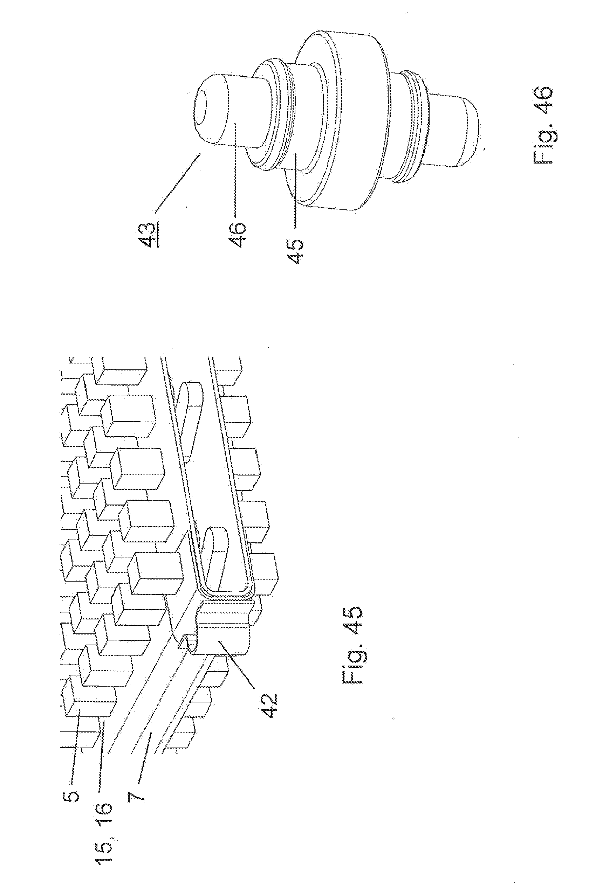

Fig. 44 zeigt ein Ausführungsbeispiel einer zweiteiligen Einsteckbuchse 42 mit einem ersten Teil 42a und einem zweiten Teil 42b. In Fig. 45 ist die zweiteilige Einsteckbuchse 42 in Verbindung mit thermoelektrischen Modulen eines TEM-Rohres gezeigt.

Die in den Figuren 40 bis 45 gezeigten beispielhaften ein- oder mehrteiligen Leiterverbinder 40, 41 und 42 können Ausformungen, z.B. Aufweitungen, Aushöhlungen, Buchsen, Biegungen, usw., aufweisen, die ein Einstecken oder Einstöpseln von TEM-Rohr-externen Leitungen oder Steckern ermöglichen.

Eine weitere Möglichkeit zum elektrisch leitfähigen Verbinden von TEM-Rohren bildet ein TEM-Rohr-Stecker.

Fig. 46 zeigt in einer isometrischen Darstellung einen TEM-Rohr-Stecker 43 gemäß einem Ausführungsbeispiel der Erfindung. Der TEM-Rohr-Stecker 43 weist einen Nicht-Leiter 45 und einen Leiter 46 auf.

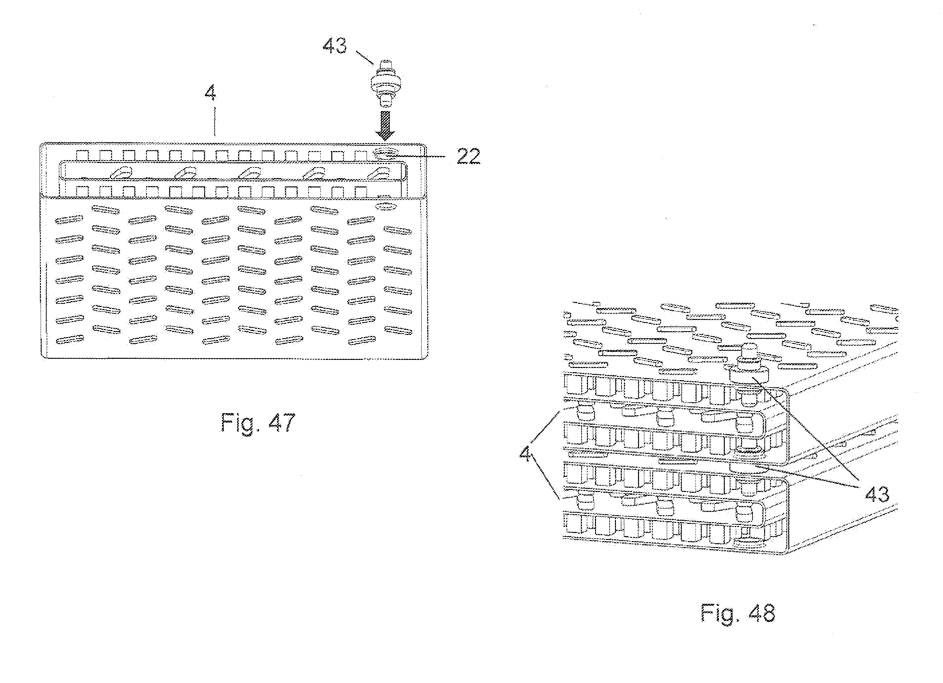

Fig. 47 zeigt in einer isometrischen Darstellung anhand eines Pfeils einen Arbeitsschritt zum Fügen des TEM-Rohr-Steckers 43.

Der TEM-Rohr-Stecker 43 verschaltet zwei TEM-Rohre 4 elektrisch miteinander. Dazu werden die beiden Enden des TEM-Rohr-Steckers 43 in die Öffnungen 22 der beiden TEM-Rohre 4 eingesteckt. Der TEM-Rohr-Stecker 43 weist den innenliegenden leitenden Kern 46 und die nicht leitende Ummantelung 45 auf. Der leitende Kern 46 kontaktiert mit leitenden Komponenten, z.B. Leitern oder Leiterverbindungen, der TEM der TEM-Rohre 4. Die nicht leitende Ummantelung 45 isoliert elektrisch im Außenbereich und in der Eintrittsstelle 22 des TEM-Rohr-Steckers 43 in das Rohr. Die Öffnung 22 wird dadurch fluiddicht. Zusätzlich kann ein dichtender Klebstoff, z.B. Silikon, angebracht werden.

Fig. 48 zeigt in einer isometrischen Darstellung ausschnittsweise eine Verschaltung von TEM-Rohren 4 via die TEM-Rohr-Stecker 43.

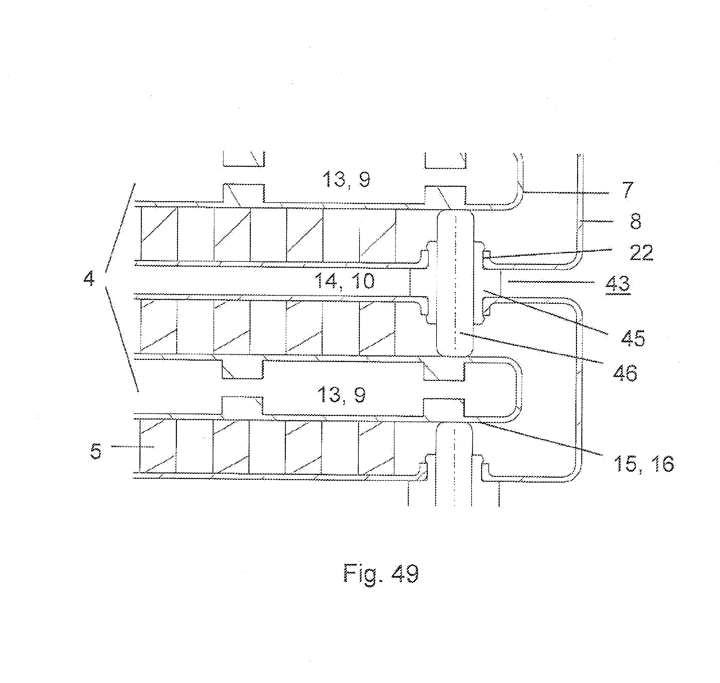

In Fig. 49 ist die Verschaltung der TEM-Rohre 4via die TEM-Rohr-Stecker 43 im Schnitt gezeigt

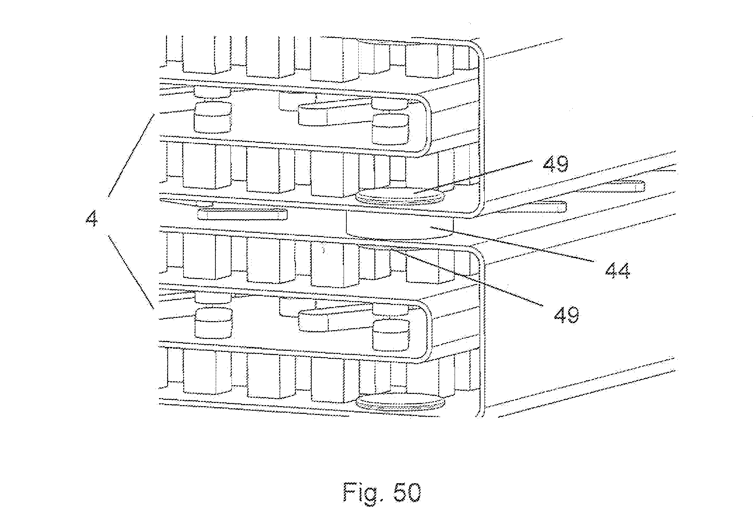

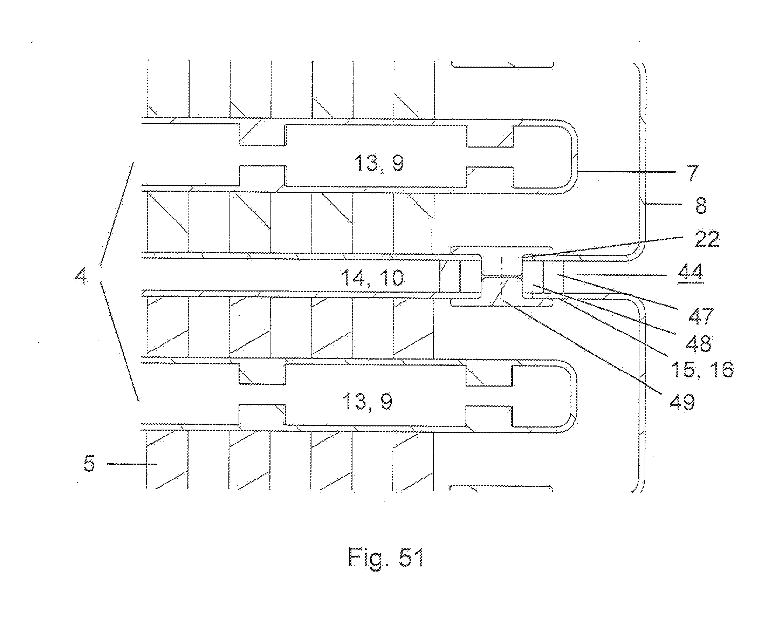

Weiterhin können TEM-Rohre 4 mittels einer Leiter-Verbindungshülse verschaltet werden, wie dies in Fig. 50 anhand eines Ausführungsbeispiels einer LeiterVerbindungshülse 44 gezeigt ist, die zwei Leiter-Dorne 49 umfasst. Fig. 51 zeigt die Verschaltung der TEM-Rohre 4 über die Leiter-Verbindungshülse 44 im Schnitt. Der elektrische Leiter 49 ragt aus der Öffnung 22 des Rohres 8 dornartig in den Außenbereich 14. Der elektrische Leiter 49 ist fluiddicht und elektrisch isoliert mit dem Rohr 8 verbunden. Der elektrische Leiter 49 ist mit der Elektrik 16 des TEM verschaltet. Die Leiter-Verbindungshülse 44 weist eine innenliegende leitende Hülse 48 und eine nicht leitende Ummantelung 47 auf. Die Dorne der elektrischen Leiter 49 zweier benachbarter TEM-Rohre 4 werden in die innenliegende leitende Hülse 48 der Leiter-Verbindungshülse 44 gesteckt und sind somit elektrisch miteinander verbunden. Die nicht leitende Ummantelung 47 isoliert elektrisch im Außenbereich 14 die Leiter-Verbindungshülse 44. Zusätzlich kann ein dichtender Klebstoff, z.B. Silikon, zwischen der Leiter-Verbindungshülse 44 und dem Rohr 8 angebracht werden.

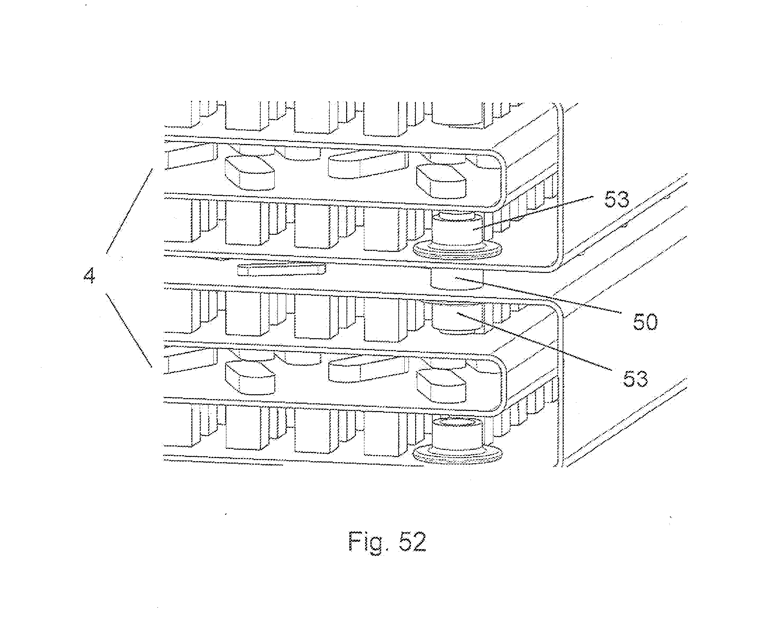

Fig. 52 zeigt in einer isometrischen Darstellung eine weitere Möglichkeit der Verschaltung von TEM-Rohren 4 über einen Leiter-Stift 50 mit einer Leiterbuchse 53.

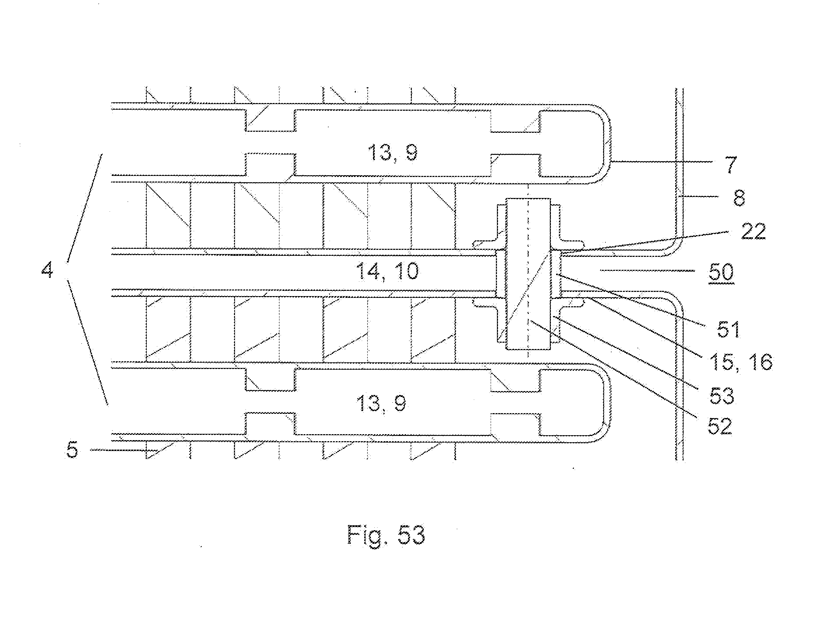

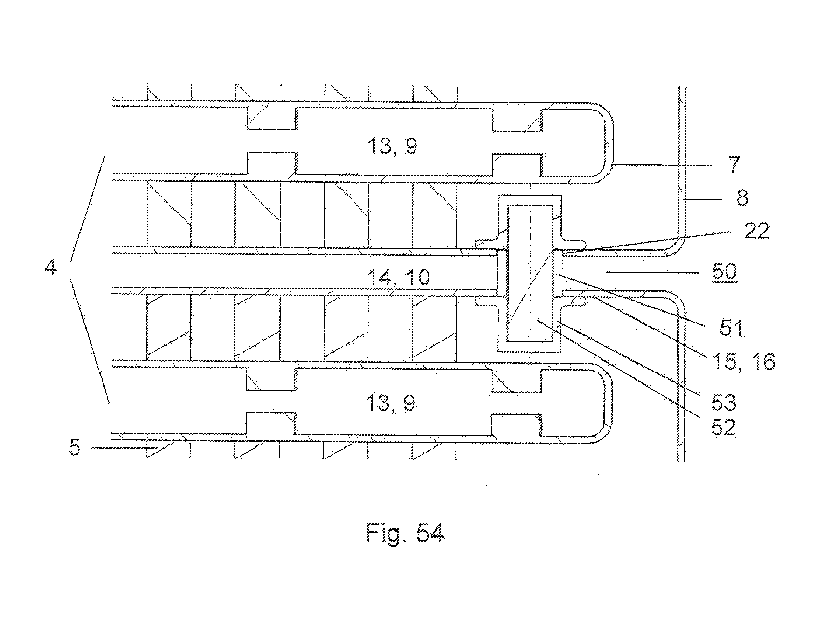

Figuren 53 und 54 zeigen in einer Schnittansicht zwei Ausführungsbeispiele für eine Verschaltung von TEM-Rohren 4 via einen Leiter-Stift 50.

Gemäß den in Figuren 52 und 53 gezeigten Ausführungsbeispielen weist die Leiterbuchse 53 ein Durchgangsloch oder Sackloch auf und ist konzentrisch zu der Öffnung 22 des Rohres 8in dem Zwischenraum zwischen dem Innenrohr 7 und dem Außenrohr 8 angebracht. Die Leiterbuchse 53 ist fluiddicht und elektrisch isoliert mit dem Rohr 8 verbunden. Die Leiterbuchse 53 ist mit der Elektrik 16 des TEM verschaltet. Der Leiter-Stift 50 weist einen innenliegenden leitenden Kern 52 und eine nicht leitende Ummantelung 51 auf. Der leitende Kern 52 kontaktiert mit den Leiterbuchsen 53 die TEM zweier benachbarter TEM-Rohre 4. Dazu werden die beiden Enden des Leiter-Stifts 50 in die Öffnungen 22 der beiden TEM-Rohre 4 eingesteckt. Die nicht leitende Ummantelung 51 isoliert elektrisch in dem Außenbereich 14 den Leiter-Stift 50. Zusätzlich kann ein dichtender Klebstoff, z.B. Silikon, zwischen dem Leiter-Stift 50 und dem Rohr 8 angebracht werden.

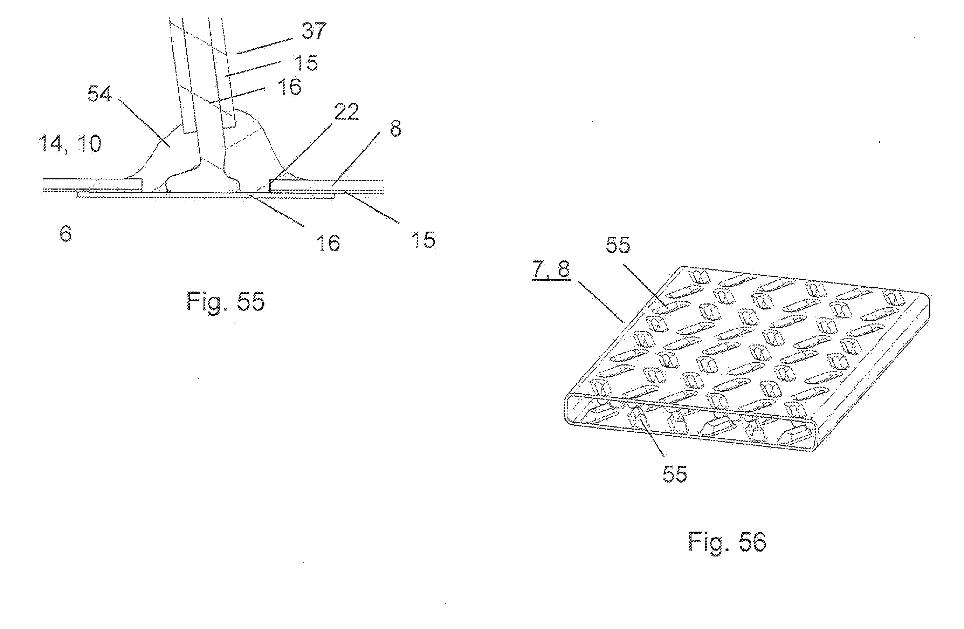

Fig. 55 zeigt im Schnitt eine alternative Möglichkeit zur Anbindung von TEM-Rohren über ein verlötetes Kabel 37.

Gemäß dem in Fig. 55 gezeigten Ausführungsbeispiel bedeckt ein elektrischer Leiter 16 die Öffnung 22 des Rohres 8 zwischenraumseitig 6. Der elektrische Leiter 16 ist fluiddicht und elektrisch isoliert mit dem Rohr 8 verbunden. Der elektrische Leiter 16 ist mit der TE-Elektrik 16 des TEM in dem TEM-Rohr verschaltet. Der leitende Kern 16 des Elektro-Kabels 37 ist außenseitig 14 mit dem elektrischen Leiter 16 elektrisch leitend verbunden, z.B. durch Löten. Die nicht leitende Ummantelung 15 des Elektro-Kabels 37 isoliert elektrisch in dem Außenbereich 14 das Elektro-Kabel 37. Eine Isolier-Masse 54, z.B. ein dichtender Klebstoff auf Silikon-Basis, in dem Öffnungsbereich 22 isoliert elektrisch den Kontaktbereich des Kabels 37 mit dem elektrischen Leiter 16 nach außen 14 hin.

Fig. 56 bis 59 zeigen isometrisch bzw. im Schnitt Umformungsmöglichkeiten der Rohrprofilierung mit dem Ziel, die elektrische Anbindung der TE-aktiven Materialien zu verbessern.

Fig. 56 zeigt in einer isometrischen Darstellung eine durch Umformung hergestellte Rohr-Profilierung 55.

Die durch Umformung, z.B. Prägung, hergestellte Profilierung 55in dem Rohr 7, 8kann die Anbindung des TEM, und insbesondere der TE-aktiven Materialien und deren elektrischer Verbindungsleiter, in dem TEM-Rohr erschweren. Die zwischenraumseitige Oberfläche des Rohres 7, 8, und insbesondere dessen Umform-Profilierung 55, kann in diesem Fall mit einem Ausfüllstoff versehen werden

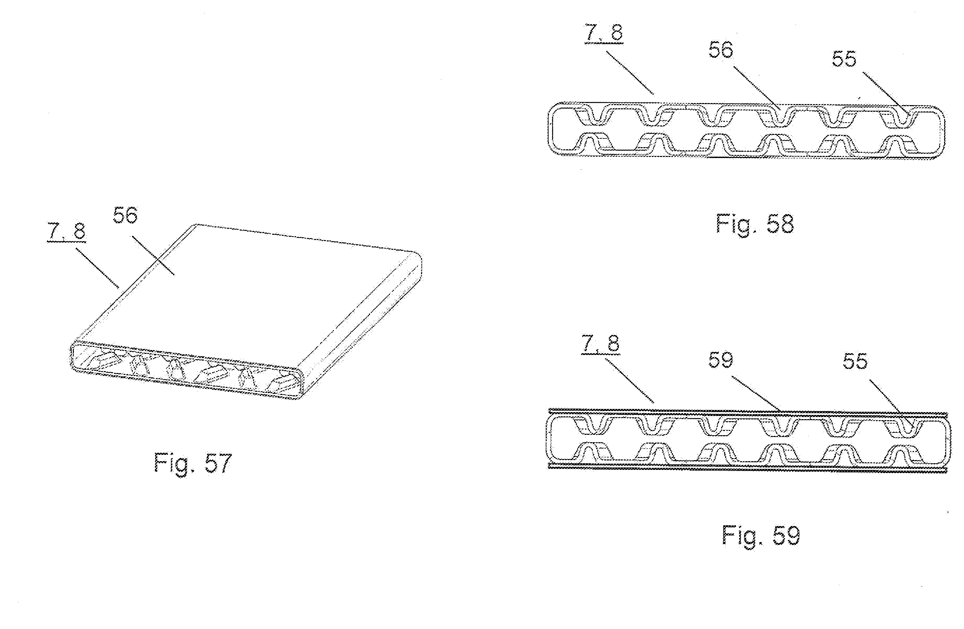

Ein entsprechendes Ausführungsbeispiel eines Ausfüllstoffs 56 zum Füllen der Umform-Rohrprofilierung 55 ist in Fig. 57 gezeigt. Bei dem Ausfüllstoff 56 kann es sich z.B. um Lot, eine Paste, einen Metallausguss, einen Kunststoffausguss, einen Keramikausguss oder einen Keramiküberzug sowie um eine Beschichtung oder Kleber handeln. Der Ausfüllstoff 56 ist ausgebildet, um eine näherungsweise ebene Anbindungsoberfläche für das TEM zu schaffen.

Fig. 58 zeigt das Ausführungsbeispiel der ausgefüllten 56UmformRohrprofilierung 55 in einer Schnittansicht.

Alternativ und/oder ergänzend kann die zwischenraumseitige Oberfläche des Rohres 7, 8mit einem ebenen Blech 59überdeckt werden, wie es anhand eines Ausführungsbeispiels in Fig. 59 im Schnitt gezeigt ist. Das Blech 59 schafft hier eine Anbindungsoberfläche für das TEM. Das Deckblech 59kann mit dem Ausfüllstoff und/oder dem Rohr 7, 8fest verbunden sein.

Im Zusammenhang mit den vorhergehend beschriebenen Figuren wurden somit eine Gestaltung und ein Aufbau des thermoelektrischen Moduls, eine Einbindung des thermoelektrischen Moduls in einen thermoelektrischen Generator sowie eine elektrische Anbindung der thermoelektrischen Module und des Generators erläutert.

Die beschriebenen Ausführungsbeispiele sind nur beispielhaft gewählt und können miteinander kombiniert werden.

### Bezugszeichenliste

- 1: TEG: Thermoelektrischer Generator
- 2: TEM: Thermoelektrisches Modul
- 3: Zwei-wandiges Rohr (Doppelrohr)
- 4: TEM-Rohr: Kombination aus TEM (2) und zwei-wandigem Rohr (3)
- 5: TE (thermolelektrisch)-aktive Materialien
- 6: Zwischenraum zwischen Außen (8)- und Innenrohr (7) des zweiwandigen Rohres (3)
- 7: Innenrohr des zwei-wandigen Rohres (3)
- 8: Außenrohr des zwei-wandigen Rohres (3)
- 9: Fluid 1
- 10: Fluid 2
- 11: Oberer und/oder unterer, ebener Spalt des Zwischenraums (6)
- 12: seitlicher Bereich des Zwischenraums (6)
- 13: innerer Bereich für Fluid 1 (9)
- 14: äußerer Bereich für Fluid 2 (10)
- 15: Nicht-Leiter: Elektrisch nicht-leitendes Material
- 16: Leiter: Elektrisch leitendes Material
- 17: Barriereschicht
- 18: Oberteil des Innen (7)- oder Außenrohres (8)
- 19: Unterteil des Innen (7)- oder Außenrohres (8)
- 20: Profilierung: Berippung, Noppen, Kiemen, Winglets, Prägung, Turbulenzeinlage
- 21: Naht im Blech des Rohres (3, 7, 8)
- 22: Öffnung im Rohr (3, 7, 8) oder TEM-Rohr-Deckel (23) für elektrische Anbindung
- 23: TEM-Rohr-Deckel
- 24: Innenkontur des TEM-Rohr-Deckel (23)
- 25: Außenkontur des TEM-Rohr-Deckel (23)
- 26: Diffusor für Fluid 1 (9)
- 27: Gehäuse für Fluid 2 (10)
- 28: Öffnung im Diffusor (26)
- 29: Öffnung im Gehäuse (27)
- 30: Boden (allgemein)
- 31: Innenrohr-Boden
- 32: Außenrohr-Boden
- 33: Öffnungen im Boden (30, 31, 32)
- 34: Zwischenraum Innenrohr-Boden (31) - Außenrohr-Boden (32)
- 35: elektrisch leitende Verbindung (Leiterverbindung) des oberen und unteren Spalts des Zwischenraums (11)
- 36: Leiterverbindung mit Buchse
- 37: elektr. Leitung (z.B.: elektrisch isoliertes Kupferkabel)
- 38: Zwei-teilige TEM-Rohr (4) - TEM-Rohr (4) - Leiterverbindung
- 39: Ein-teilige TEM-Rohr (4) - TEM-Rohr (4) - Leiterverbindung
- 40: Einsteckleiter
- 41: Einsteckbuchse
- 42: Zwei-teilige Einsteckbuchse
- 43: TEM-Rohr-Stecker
- 44: Leiter-Verbindungshülse
- 45: Nicht-Leiter des TEM-Rohr-Steckers (43)
- 46: Leiter des TEM-Rohr-Steckers (43)
- 47: Nicht-Leiter der Leiter-Verbindungshülse (44)
- 48: Leiter der Leiter-Verbindungshülse (44)
- 49: Leiter-Dorn
- 50: Leiter-Stift
- 51: Nicht-Leiter des Leiter-Stifts (50)
- 52: Leiter des Leiter-Stifts (50)
- 53: Leiter-Buchse
- 54: Isolier-Masse
- 55: Durch Umformung hergestellte Profilierung (20)
- 56: Ausfüllstoff (z.B. Lot, Paste, Metallausguss, Kunststoffausguss, Keramikausguss oder -Überzug oder -Beschichtung, Kleber)
- 57: Buchse
- 58: Ausprägung des Leiterverbinders (38)
- 59: Deckblech

## Patentansprüche

1. Thermoelektrische Einheit mit folgenden Merkmalen:
einem ersten thermoelektrischen Modul (2), das eine Mehrzahl von miteinander verschalteten thermoelektrischen Elementen (5) aufweist, wobei das erste thermoelektrische Modul zwischen einer Hauptfläche eines Innenflachrohres (7) und einer Hauptfläche eines Außenflachrohres (8) eines doppelwandigen Kühlungsrohres (3) angeordnet ist;
einem zweiten thermoelektrischen Modul (2), das eine Mehrzahl von miteinander verschalteten thermoelektrischen Elementen (5) aufweist, wobei das zweite thermoelektrische Modul zwischen einer weiteren Hauptfläche des Innenflachrohres (7) und einer weiteren Hauptfläche des Außenflachrohres (8) des doppelwandigen Kühlungsrohres (3) und/oder zwischen einer Hauptfläche eines Innenflachrohres und einer Hauptfläche eines Außenflachrohres eines weiteren doppelwandigen Kühlungsrohres angeordnet ist; und
einem elektrischen Verbinder (35; 36; 37; 38; 39; 40; 41; 42; 43; 44; 49; 50; 58), der ausgebildet ist, um das erste thermoelektrische Modul mit dem zweiten thermoelektrischen Modul elektrisch leitfähig zu verbinden.

2. Thermoelektrische Einheit gemäß Anspruch 1, bei der das Innenflachrohr (7) des doppelwandigen Kühlungsrohres (3) eine größere Länge als das Außenflachrohr (8) des doppelwandigen Kühlungsrohres und das Innenflachrohr des weiteren doppelwandigen Kühlungsrohres eine größere Länge als das Außenflachrohr (8) des weiteren doppelwandigen Kühlungsrohres aufweist, derart, dass zumindest an einer Seite die Enden der Innenflachrohre über die entsprechenden Enden der Außenflachrohre vorstehen, wobei sich der elektrische Verbinder vom hervorstehenden Ende des Innenrohres des doppelwandigen Kühlungsrohres (3) zu dem hervorstehenden Ende des Innenrohres des weiteren doppelwandigen Kühlungsrohres erstreckt.

3. Thermoelektrische Einheit gemäß einem der vorangegangenen Ansprüche, bei der der elektrische Verbinder (35) als eine einteilige Klammer (35) ausgebildet ist, die das Innenflachrohr (7) an einer Seitenfläche des doppelwandigen Kühlungsrohres (3) seitlich umspannt, wobei ein erstes Ende des Verbinders das erste thermoelektrische Modul (2) des doppelwandigen Kühlungsrohres kontaktiert und ein zweites Ende oder ein Zwischenkontakt des Verbinders das weitere thermoelektrische Modul (2) des doppelwandigen Kühlungsrohres kontaktiert.

4. Thermoelektrische Einheit gemäß einem der vorangegangenen Ansprüche, bei der der elektrische Verbinder (39) als eine einteilige Mehrfachklammer (39) ausgebildet ist, die das Innenflachrohr (7) des doppelwandigen Kühlungsrohres (3) und das Innenflachrohr des mindestens einen weiteren doppelwandigen Kühlungsrohres an einer Seitenfläche seitlich umspannt, wobei die Mehrfachklammer ausgebildet ist, um zwei dem doppelwandigen Kühlungsrohr zugeordnete thermoelektrische Module mit mindestens einem thermoelektrischen Modul eines weiteren doppelwandigen Kühlungsrohres zu verbinden.

5. Thermoelektrische Einheit gemäß einem der vorangegangenen Ansprüche , bei der der elektrische Verbinder (38) als eine mehrteilige Klammer (38) ausgebildet ist, von der ein erster Teil (38a) eine Seitenfläche des Innenflachrohrs (7) des doppelwandigen Kühlungsrohres (3) umspannt oder bedeckt und mindestens ein zweiter Teil (38b) das Innenflachrohr eines weiteren doppelwandigen Kühlungsrohres an einer Seitenfläche umspannt oder überdeckt, wobei der erste Teil und der zweite Teil formschlüssig verbindbar sind, um zumindest ein dem doppelwandigen Kühlungsrohr zugeordnetes thermoelektrisches Modul mit mindestens einem dem weiteren doppelwandigen Kühlungsrohr zugeordneten thermoelektrischen Modul elektrisch leitfähig zu verbinden.

6. Thermoelektrische Einheit gemäß einem der vorangegangenen Ansprüche, bei der der elektrische Verbinder (49) um eine schmale Seite des Innenrohres gespannt ist und im Bereich einer die Hauptflächen des Innenrohres verbindenden Nebenfläche des Innenrohres eine Buchse (41, 42a, 57) aufweist, die ausgebildet ist, um mit einem Einsteckleiter (37) elektrisch leitfähig verbunden zu werden.

7. Thermoelektrische Einheit gemäß einem der vorangegangenen Ansprüche, bei der das Außenflachrohr (8) des doppelwandigen Kühlungsrohres (3) eine erste Öffnung (22) aufweist und an einer Hauptoberfläche des Außenflachrohres des weiteren doppelwandigen Kühlungsrohres eine zweite Öffnung aufweist, die an einer der ersten Öffnung gegenüberliegenden Position angeordnet ist und wobei der elektrische Verbinder als Steckstift (44, 45, 50) ausgebildet ist, der durch die erste Öffnung (22) und die zweite öffnung hindurch geführt ist.

8. Thermoelektrische Einheit gemäß Anspruch 7, bei der der Steckstift (44, 45, 50) eine nicht-leitende Ummantelung (45) aufweist.

9. Thermoelektrische Einheit gemäß einem der vorangegangenen Ansprüche , bei der der elektrische Verbinder (35; 36; 37; 38; 39; 40; 41; 42; 43; 44; 50) einen ersten Teil (49) aufweist, der als ein mit dem thermoelektrischen Modul (2) elektrisch leitfähig verbundener Dorn (49) ausgebildet ist, der aus einer Öffnung (22) einer Hauptfläche des Außenflachrohres (8) des doppelwandigen Kühlungsrohres (3) herausragt, und wobei der elektrische Verbinder (49) ferner einen zweiten Teil (49) aufweist, der ebenfalls als elektrisch leitfähiger Dorn (49) ausgebildet ist, wobei der zweite Teil (49) mit einem zweiten thermoelektrischen Modul (2) leitfähig verbunden ist, das einem weiteren doppelwandigen Kühlungsrohr zugeordnet ist und der zweite Teil aus einer Öffnung (22) einer Hauptfläche des Außenflachrohres (8) des weiteren doppelwandigen Kühlungsrohres (3) herausragt, wobei der erste und zweite Teil des elektrischen Verbinders in elektrisch leitfähigem Kontakt miteinander stehen.

10. Thermoelektrische Einheit gemäß einem der vorangegangenen Ansprüche, bei der der elektrische Verbinder (37) als ein Kabel (37) ausgebildet ist, dessen Ende durch eine Öffnung (22) einer Hauptfläche des Außenflachrohres (8) des doppelwandigen Kühlungsrohres (3) mit dem thermoelektrischen Modul (2) stoffschlüssig und elektrisch leitend verbunden ist.

## Claims

1. A thermoelectric unit with the following features:
a first thermoelectric module (2), which has a plurality of thermoelectric elements (5) interconnected to one another, wherein the first thermoelectric module being arranged between a main surface of an inner flat tube (7) and a main surface of an outer flat tube (8) of a double-walled cooling tube (3);
a second thermoelectric module (2) that has a plurality of thermoelectric elements (5) interconnected to one another, wherein the second thermoelectric module being arranged between a further main surface of the inner flat tube (7) and a further main surface of the outer flat tube (8) of the double-walled cooling tube (3) and/or between a main surface of an inner flat tube and a main surface of an outer flat tube of a further double-walled cooling tube; and
an electrical connector (35; 36; 37; 38; 39; 40; 41; 42; 43; 44; 49; 50; 58) configured to connect the first thermoelectric module to the second thermoelectric module in an electrically conducting manner.

2. The thermoelectric unit according to claim 1, wherein the inner flat tube (7) of the double-walled cooling tube (3) has a greater length than the outer flat tube (8) of the double-walled cooling tube and the inner flat tube of the further double-walled cooling tube has a greater length than the outer flat tube (8) of the further double-walled cooling tube such that at least on one side the ends of the inner flat tubes project beyond corresponding ends of the outer flat tubes, and wherein the electrical connector extends from the protecting end of the inner tube of the double-walled cooling tube (3) towards the projecting end of the inner tube of the further double-walled cooling tube.

3. The thermoelectric unit according to any one of preceding claims, wherein the electrical convector (35) is embodied as a one-part clamp (35), which literally spans the inner flat tube (7) on a literal surface of the double-walled cooling tube (3), wherein a first end of the convector contacts the first thermoelectric module (2) of the double-walled cooling tube and a second end or an intermediate contact of the convector contracts the further thermoelectric module (2) of the double-walled cooling tube.

4. The thermoelectric unit according to any one of preceding claims, wherein the electric convector (39) is a one-part multiple convector clamp (39) that laterally clamps the inner flat tube (7) of the double-walled cooling tube (3) and the inner flat tube of the at least one further double-walled cooling tube on one lateral surface, and wherein the multiple convector clamp is configured to connect two thermoelectric modules assigned to the double-walled cooling tube to at least one thermoelectric module of a further double-walled cooling tube.

5. The thermoelectric unit according to any one of preceding claims, wherein the electrical connector (38) is a multipart clamp (38), of which a first part (38a) spans or covers a lateral surface of the inner flat tube (7) of the double-walled cooling tube (3) and at least one second part (38b) spans or covers the inner flat tube of a further double-walled cooling tube on a lateral surface, and wherein the first part and the second part are connectable positively in order to connect in an electrically conductive manner at least one thermoelectric module assigned to the double-walled cooling tube to at least one thermoelectric module assigned to the further double-walled cooling tube.

6. The thermoelectric unit according to any one of preceding claims, wherein the electrical connector (49) is spanned by a narrow side of the inner tube and has a bushing (41, 42a, 57) in the region of a subsidiary surface of the inner tube connecting the main surfaces of the inner tube, which bushing is configured to be connectable to an insert conductor (37) in an electrically conducting manner.

7. The thermoelectric unit according to any one of preceding claims, wherein the outer flat tube (8) of the double-walled cooling tube (3) has a first opening (22) and, on a main surface of the outer flat tube of the further double-walled cooling tube, has a second opening, which is arranged at a position lying opposite the first opening, and wherein the electrical connector is a pin plug (44, 45, 50) that is guided through the first opening (22) and the second opening.

8. The thermoelectric unit according to claim 7, wherein the pin plug (44, 45, 50) has a non-conducting sheath (45).

9. The thermoelectric unit according to any one of preceding claims, wherein the electric connector (35; 36; 37; 38; 39; 40; 41; 42; 43; 44; 50) has a first part (49), which is configured as a prong (49) connectable to the thermoelectric module (2) in an electrically conducting manner, which prong projects out of an opening (22) of a main surface of the outer flat tube (8) of the double-walled cooling tube (3), and wherein the electrical connector (49) has a second part (49), which is also configured as an electrically conducting prong (49), wherein the second part (49) is connectable to a second thermoelectric module (2) in a conducting manner, which is assigned to a further double-walled cooling tube, and the second part projects out of an opening (22) of a main surface of the outer flat tube (8) of the further double-walled cooling tube (3), and wherein the first and the second part of the electrical connector are in electrically conducting contact with one another.

10. The thermoelectric unit according to any one of preceding claims, wherein the electrical connector (37) is a cable (37), an end of which is connected through an opening (22) of a main surface of the outer flat tube (8) of the double-walled cooling tube (3) to the thermoelectric module (2) is an adhesive and electrically conducting manner.

## Revendications

1. Unité thermoélectrique ayant les caractéristiques suivantes :
un premier module thermoélectrique (2) qui présente une pluralité d'éléments thermoélectriques (5) connectés les uns aux autres, où le module thermoélectrique est disposé entre une surface principale d'un tube plat intérieur (7) et une surface principale d'un tube plat extérieur (8) d'un tube de refroidissement (3) à double paroi ;
un deuxième module thermoélectrique (2) qui présente une pluralité d'éléments thermoélectriques (5) connectés les uns aux autres, où le deuxième module thermoélectrique est disposé entre une autre surface principale du tube plat intérieur (7) et une autre surface principale du tube plat extérieur (8) du tube de refroidissement (3) à double paroi et / ou entre une surface principale d'un tube plat intérieur et une surface principale d'un tube plat extérieur d'un autre tube de refroidissement à double paroi ; et
un connecteur électrique (35; 36; 37; 38; 39; 40; 41; 42; 43; 44; 49; 50; 58) qui est conçu pour connecter le premier module thermoélectrique au deuxième module thermoélectrique, de façon électroconductrice.

2. Unité thermoélectrique selon la revendication 1, dans laquelle le tube plat intérieur (7) du tube de refroidissement (3) à double paroi présente une longueur plus grande que celle du tube plat extérieur (8) du tube de refroidissement à double paroi, et le tube plat intérieur de l'autre tube de refroidissement à double paroi présente une longueur plus grande que celle du tube plat extérieur (8) de l'autre tube de refroidissement à double paroi, de manière telle, qu'au moins sur un côté, les extrémités des tubes plats intérieurs dépassent des extrémités correspondantes des tubes plats extérieurs, où le connecteur électrique s'étend depuis l'extrémité saillante du tube intérieur du tube de refroidissement (3) à double paroi, jusqu'à l'extrémité saillante du tube intérieur de l'autre tube de refroidissement à double paroi.

3. Unité thermoélectrique selon l'une ou l'autre des revendications précédentes, dans laquelle le connecteur électrique (35) est conçu comme un clip (35), d'une seule pièce, qui entoure latéralement le tube plat intérieur (7) au niveau d'une surface latérale du tube de refroidissement (3) à double paroi, où une première extrémité du connecteur est au contact du premier module thermoélectrique (2) du tube de refroidissement à double paroi, et une seconde extrémité ou un contact intermédiaire du connecteur est au contact de l'autre module thermoélectrique (2) du tube de refroidissement à double paroi.

4. Unité thermoélectrique selon l'une quelconque des revendications précédentes, dans laquelle le connecteur électrique (39) est conçu comme un clip multiple (39), d'une seule pièce, qui entoure latéralement, au niveau d'une surface latérale, le tube plat intérieur (7) du tube de refroidissement (3) à double paroi et le tube plat intérieur de l'autre tube de refroidissement à double paroi au moins au nombre de un, où le clip multiple est configuré pour connecter deux modules thermoélectriques associés au tube de refroidissement à double paroi, à au moins un module thermoélectrique d'un autre tube de refroidissement à double paroi.

5. Unité thermoélectrique selon l'une quelconque des revendications précédentes, dans laquelle le connecteur électrique (38) est conçu comme un clip (38) en plusieurs parties, dont une première partie (38a) entoure ou recouvre une surface latérale du tube intérieur plat (7) du tube de refroidissement (3) à double paroi et, au moins une deuxième partie (38b) entoure ou recouvre, au niveau d'une surface latérale, le tube intérieur plat d'un autre tube de refroidissement à double paroi, où la première partie et la deuxième partie peuvent être assemblées par complémentarité de forme, pour connecteur de façon électroconductrice au moins un module thermoélectrique associé au tube de refroidissement à double paroi, à au moins un module thermoélectrique associé à l'autre tube de refroidissement à double paroi.

6. Unité thermoélectrique selon l'une quelconque des revendications précédentes, dans laquelle le connecteur électrique (49) est serré autour d'un côté étroit du tube intérieur et, dans la zone d'une surface secondaire du tube intérieur, qui relie les surfaces principale du tube intérieur, présente une douille (41, 42a, 57) qui est configurée pour être connectée à un conducteur enfichable (37), de façon électroconductrice.

7. Unité thermoélectrique selon l'une quelconque des revendications précédentes, dans laquelle le tube plat extérieur (8) du tube de refroidissement (3) à double paroi présente une première ouverture (22) et, sur une surface principal du tube plat extérieur de l'autre tube de refroidissement à double paroi, présente une seconde ouverture qui est disposée au niveau d'une position faisant face à la première couverture, et où le connecteur électrique est conçu comme une fiche de contact (44, 45, 50) qui est guidée à travers la première ouverture (22) et la seconde couverture.

8. Unité thermoélectrique selon la revendication 7, dans laquelle la fiche de contact (44, 45, 50) présente un enrobage (45) non conducteur.

9. Unité thermoélectrique selon l'une quelconque des revendications précédentes, dans laquelle le connecteur électrique (35; 36; 37; 38; 39; 40; 41; 42; 43; 44; 50) présente une première partie (49) qui est conçue comme une broche (49) reliée de façon électroconductrice au module thermoélectrique (2), laquelle broche dépasse d'une ouverture (22) d'une surface principale du tube plat extérieur (8) du tube de refroidissement (3) à double paroi, et où le connecteur électrique (49) présente en outre une deuxième partie (49) qui est conçue également comme une broche (49) électroconductrice, ou la deuxième partie (49) est reliée de façon conductrice à un deuxième module thermoélectrique (2) qui est associé à un autre tube de refroidissement à double paroi, et la deuxième partie dépasse d'une ouverture (22) d'une surface principale du tube plat extérieur (8) de l'autre tube de refroidissement (3) à double paroi, où les première et deuxième parties du connecteur électrique sont au contact l'une de l'autre de façon électroconductrice.

10. Unité thermoélectrique selon l'une quelconque des revendications précédentes, dans laquelle le connecteur électrique (37) est conçu comme un câble (37) dont l'extrémité est reliée au module thermoélectrique (2), par continuité de matière et de façon électroconductrice, à travers une ouverture (22) d'une surface principale du tube plat extérieur (8) du tube de refroidissement (3) à double paroi.
